(19) Europäisches Patentamt
European Patent Office
Office européen des brevets

(11) **EP 2 465 149 B1**

(12) **EUROPÄISCHE PATENTSCHRIFT**

(45) Veröffentlichungstag und Bekanntmachung des Hinweises auf die Patenterteilung:
**22.01.2014 Patentblatt 2014/04**

(21) Anmeldenummer: **10737333.4**

(22) Anmeldetag: **30.07.2010**

(51) Int Cl.:
*H01L 51/52* *(2006.01)*       *C09J 7/02* *(2006.01)*
*C09J 7/00* *(2006.01)*       *C09J 153/02* *(2006.01)*

(86) Internationale Anmeldenummer:
**PCT/EP2010/061095**

(87) Internationale Veröffentlichungsnummer:
**WO 2011/018358 (17.02.2011 Gazette 2011/07)**

(54) **VERFAHREN ZUR KAPSELUNG EINER ELEKTRONISCHEN ANORDNUNG**

METHOD FOR ENCAPSULATING AN ELECTRONIC ARRANGEMENT

PROCÉDÉ D'ENCAPSULATION D'UN ENSEMBLE ÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **12.08.2009 DE 102009036970**

(43) Veröffentlichungstag der Anmeldung:
**20.06.2012 Patentblatt 2012/25**

(73) Patentinhaber: **TESA SE**
**20253 Hamburg (DE)**

(72) Erfinder:
• **STEEN, Alexander**
  **53175 Bonn (DE)**
• **KRAWINKEL, Thorsten**
  **22457 Hamburg (DE)**
• **KEITE-TELGENBÜSCHER, Klaus**
  **22529 Hamburg (DE)**
• **ELLINGER, Jan**
  **20257 Hamburg (DE)**

(56) Entgegenhaltungen:
**WO-A1-2008/043660     US-A1- 2003 143 423**

## Beschreibung

Die vorliegende Erfindung betrifft ein Verfahren zur Kapselung einer elektronischen Anordnung gemäß dem Oberbegriff von Anspruch 1 sowie die Verwendung einer Haftklebemasse zur Kapselung einer elektronischen Anordnung gemäß dem Oberbegriff von Anspruch 5.

(Opto-)Elektronische Anordnungen werden immer häufiger in kommerziellen Produkten verwendet oder stehen kurz vor der Markteinführung. Derartige Anordnungen umfassen anorganische oder organische elektronische Strukturen, beispielsweise organische, metallorganische oder polymere Halbleiter oder auch Kombinationen dieser. Diese Anordnungen und Produkte sind je nach gewünschter Anwendung starr oder flexibel ausgebildet, wobei eine zunehmende Nachfrage nach flexiblen Anordnungen besteht. Die Herstellung derartiger Anordnungen erfolgt beispielsweise durch Druckverfahren, wie Hochdruck, Tiefdruck, Siebdruck, Flachdruck oder auch so genanntes "non impact printing", wie etwa Thermotransferdruck, Tintenstrahldruck oder Digitaldruck. Vielfach werden aber auch auch Vakuumverfahren, wie z.B. Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung, verwendet, wobei die Strukturierung in der Regel durch Masken erfolgt.

Als Beispiele für bereits kommerzielle oder in ihrem Marktpotential interessante (opto-) elektronische Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung genannt, Elektrolumineszenzlampen, lichtemittierende elektrochemische Zellen (LEECs), organische Solarzellen, bevorzugt Farbstoff- oder Polymersolarzellen, anorganische Solarzellen, bevorzugt Dünnschichtsolarzellen, insbesondere auf der Basis von Silizium, Germanium, Kupfer, Indium und Selen, organische Feldeffekt-Transistoren, organische Schaltelemente, organische optische Verstärker, organische Laserdioden, organische oder anorganische Sensoren oder auch organische- oder anorganischbasierte RFID-Transponder angeführt.

Als technische Herausforderung für die Realisierung ausreichender Lebensdauer und Funktion von (opto-) elektronischen Anordnungen im Bereich der anorganischen und/oder organischen (Opto-)Elektronik, ganz besonders aber im Bereich der organischen (Opto-) Elektronik ist ein Schutz der darin enthaltenen Komponenten vor Permeanten zu sehen. Permeanten können eine Vielzahl von niedermolekularen organischen oder anorganischen Verbindungen sein, insbesondere Wasserdampf und Sauerstoff.

Eine Vielzahl von (opto-)elektronischen Anordnungen im Bereich der anorganischen und/oder organischen (Opto-)Elektronik, ganz besonders bei Verwendung von organischen Rohstoffen, ist sowohl gegen Wasserdampf als auch gegen Sauerstoff empfindlich, wobei für viele Anordnungen das Eindringen von Wasser oder Wasserdampf als größeres Problem eingestuft wird. Während der Lebensdauer der elektronischen Anordnung ist deshalb ein Schutz durch eine Verkapselung erforderlich, da andernfalls die Leistung über den Anwendungszeitraum nachlässt. So kann sich beispielsweise durch eine Oxidation der Bestandteile etwa bei lichtemittierenden Anordnungen wie Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kürzester Zeit drastisch verringern.

Bei der anorganischen und/oder organischen (Opto-)Elektronik, insbesondere bei der organischen (Opto-) Elektronik, gibt es besonderen Bedarf für flexible Klebelösungen, die eine Permeationsbarriere für Permeanten, wie Sauerstoff und/oder Wasserdampf, darstellen. Daneben gibt es eine Vielzahl von weiteren Anforderungen für derartige (opto)-elektronische Anordnungen. Die flexiblen Klebelösungen sollen daher nicht nur eine gute Haftung zwischen zwei Substraten erzielen, sondern zusätzlich Eigenschaften wie hohe Scherfestigkeit und Schälfestigkeit, chemische Beständigkeit, Alterungsbeständigkeit, hohe Transparenz, einfache Prozessierbarkeit sowie hohe Flexibilität und Biegsamkeit erfüllen.

Ein nach dem Stand der Technik gängiger Ansatz ist deshalb, die elektronische Anordnung zwischen zwei für Wasserdampf und Sauerstoff undurchlässige Substrate zu legen. Anschließend erfolgt dann eine Versiegelung an den Rändern. Für unflexible Aufbauten werden Glas oder Metallsubstrate verwendet, die eine hohe Permeationsbarriere bieten, aber sehr anfällig für mechanische Belastungen sind. Ferner verursachen diese Substrate eine relativ große Dicke der gesamten Anordnung. Im Falle von Metallsubstraten besteht zudem keine Transparenz. Für flexible Anordnungen hingegen kommen Flächensubstrate, wie transparente oder nicht transparente Folien, zum Einsatz, die mehrlagig ausgeführt sein können. Hierbei können sowohl Kombinationen aus verschieden Polymeren, als auch anorganische oder organische Schichten verwendet werden. Der Einsatz solcher Flächensubstrate ermöglicht einen flexiblen, äußerst dünnen Aufbau. Dabei sind für die verschiedenen Anwendungen unterschiedlichste Substrate, wie z.B. Folien, Gewebe, Vliese und Papiere oder Kombinationen daraus möglich.

Um eine möglichst gute Versiegelung zu erzielen, werden spezielle Barriereklebemassen verwendet. Eine gute Klebemasse für die Versiegelung von (opto-)elektronischen Bauteilen weist eine geringe Permeabilität gegen Sauerstoff und insbesondere gegen Wasserdampf auf, hat eine ausreichende Haftung auf der Anordnung und kann gut auf diese auffließen. Eine geringe Haftung auf der Anordnung verringert die Barrierewirkung an der Grenzfläche, wodurch ein Eintritt von Sauerstoff und Wasserdampf unabhängig von den Eigenschaften der Klebmasse ermöglicht wird. Nur wenn der Kontakt zwischen Masse und Substrat durchgängig ist, sind die Masseeigenschaften der bestimmende Faktor für die Barrierewirkung der Klebemasse.

Zur Charakterisierung der Barrierewirkung werden üblicherweise die Sauerstofftransmissionsrate OTR (Oxygen Transmission Rate) sowie die Wasserdampftransmissionsrate WVTR (Water Vapor Transmission Rate) angegeben. Die jeweilige Rate gibt dabei den flächen- und zeitbezogenen Fluss von Sauerstoff bzw. Wasserdampf durch einen Film unter spezifischen Bedingungen von Temperatur und Partialdruck sowie ggf. weiterer Messbedingungen wie relativer Luftfeuchtigkeit an. Je geringer diese Werte sind, desto besser ist das jeweilige Material zur Kapselung geeignet. Die Angabe der Permeation basiert dabei nicht allein auf den Werten für WVTR oder OTR sondern beinhaltet immer auch eine Angabe zur mittleren Weglänge der Permeation, wie z.B. die Dicke des Materials, oder eine Normalisierung auf eine bestimmte Weglänge.

Die Permeabilität P ist ein Maß für die Durchlässigkeit eines Körpers für Gase und/oder Flüssigkeiten. Ein niedriger P-Wert kennzeichnet eine gute Barrierewirkung. Die Permeabilität P ist ein spezifischer Wert für ein definiertes Material und einen definierten Permeanten unter stationären Bedingungen bei bestimmter Permeationsweglänge, Partialdruck und Temperatur. Die Permeabilität P ist das Produkt aus Diffusions-Term D und Löslichkeits-Term S:

$$P = D * S$$

Der Löslichkeitsterm S beschreibt vorliegend die Affinität der Barriereklebemasse zum Permeanten. Im Fall von Wasserdampf wird beispielsweise ein geringer Wert für S von hydrophoben Materialen erreicht. Der Diffusionsterm D ist ein Maß für die Beweglichkeit des Permeanten im Barrierematerial und ist direkt abhängig von Eigenschaften, wie der Molekülbeweglichkeit oder dem freien Volumen. Oft werden bei stark vernetzten oder hochkristallinen Materialen für D relativ niedrige Werte erreicht. Hochkristalline Materialien sind jedoch in der Regel weniger transparent und eine stärkere Vernetzung führt zu einer geringeren Flexibilität. Die Permeabilität P steigt üblicherweise mit einer Erhöhung der molekularen Beweglichkeit an, etwa auch wenn die Temperatur erhöht oder der Glasübergangspunkt überschritten wird.

Ansätze, um die Barrierewirkung einer Klebemasse zu erhöhen, müssen die beiden Parameter D und S insbesondere berücksichtigen, im Hinblick auf den Einfluss auf die Durchlässigkeit von Wasserdampf und Sauerstoff. Zusätzlich zu diesen chemischen Eigenschaften müssen auch Auswirkungen physikalischer Einflüsse auf die Permeabilität bedacht werden, insbesondere die mittlere Permeationsweglänge und Grenzflächeneigenschaften (Auffließverhalten der Klebemasse, Haftung). Die ideale Barriereklebemasse weist geringe D-Werte und S-Werte bei sehr guter Haftung auf dem Substrat auf.

Ein geringer Löslichkeits-Term S ist meist unzureichend, um gute Barriereeigenschaften zu erreichen. Ein klassisches, Beispiel dafür sind insbesondere Siloxan-Elastomere. Die Materialien sind äußerst hydrophob (kleiner Löslichkeits-Term), weisen aber durch ihre frei drehbare Si-O Bindung (großer Diffusions-Term) eine vergleichsweise geringe Barrierewirkung gegen Wasserdampf und Sauerstoff auf. Für eine gute Barrierewirkung ist also eine gute Balance zwischen Löslichkeits-Term S und Diffusions-Term D notwendig.

Hierfür wurden bisher vor allem Flüssigklebstoffe und Adhäsive auf Basis von Epoxiden verwendet (WO98/21287 A1; US 4,051,195 A; US 4,552,604 A). Diese haben durch eine starke Vernetzung einen geringen Diffusionsterm D. Ihr Haupteinsatzgebiet sind Randverklebungen starrer Anordnungen, aber auch mäßig flexible Anordnungen. Eine Aushärtung erfolgt thermisch oder mittels UV-Strahlung. Eine vollflächige Verklebung ist aufgrund des durch die Aushärtung auftreten Schrumpfes kaum möglich, da es beim Aushärten zu Spannungen zwischen Kleber und Substrat kommt, die wiederum zur Delaminierung führen können.

Der Einsatz dieser flüssigen Klebstoffe birgt eine Reihe von Nachteilen. So können niedermolekulare Bestandteile (VOC - volatile organic compound) die empfindlichen elektronischen Strukturen der Anordnung schädigen und den Umgang in der Produktion erschweren. Der Klebstoff muss aufwendig auf jeden einzelnen Bestandteil der Anordnung aufgebracht werden. Die Anschaffung von teuren Dispensern und Fixiereinrichtungen ist notwendig, um eine genaue Positionierung zu gewährleisten. Die Art der Auftragung verhindert zudem einen schnellen kontinuierlichen Prozess und auch durch den anschließend erforderlichen Laminationsschritt kann durch die geringe Viskosität das Erreichen einer definierten Schichtdicke und Verklebungsbreite in engen Grenzen erschwert sein.

Des Weiteren weisen solche hochvernetzten Klebstoffe nach dem Aushärten nur noch eine geringe Flexibilität auf. Der Einsatz von thermisch-vernetzenden Systemen wird im niedrigen Temperaturbereich oder bei 2-Komponenten-Systemen durch die Topfzeit begrenzt, also die Verarbeitungszeit bis eine Vergelung stattgefunden hat. Im hohen Temperaturbereich und insbesondere bei langen Reaktionszeiten begrenzen wiederum die empfindlichen (opto-) elektronischen Strukturen die Verwendbarkeit derartiger Systeme - die maximal anwendbaren Temperaturen bei (opto-) elektronischen Strukturen liegen oft bei 90°C, da bereits ab dieser Temperatur eine Vorschädigung eintreten kann. Insbesondere flexible Anordnungen, die organische Elektronik enthalten und mit transparenten Polymerfolien oder Verbunden aus Polymerfolien und anorganischen Schichten gekapselt sind, setzen hier enge Grenzen. Dies gilt auch für Laminierschritte unter großem Druck. Um eine verbesserte Haltbarkeit zu erreichen, ist hier ein Verzicht auf einen hoch temperaturbelastenden Schritt und eine Laminierung unter geringerem Druck von Vorteil.

Alternativ zu den thermisch härtbaren Flüssigklebstoffen werden mittlerweile vielfach auch strahlenhärtende Klebstoffe eingesetzt (US 2004/0225025 A1). Die Verwendung von strahlenhärtenden Klebstoffen vermeidet eine lange andauernde Wärmebelastung der elektronischen Anordnung. Jedoch kommt es durch die Bestrahlung zu einer kurzfristigen punktuellen Erhitzung der Anordnung, da neben einer UV-Strahlung in der Regel auch ein sehr hoher Anteil an IR-Strahlung emittiert wird. Weitere oben genannte Nachteile von Flüssigklebstoffen wie VOC, Schrumpf, Delamination und geringe Flexibilität bleiben ebenfalls erhalten. Probleme können durch zusätzliche flüchtige Bestandteile oder Spaltprodukte aus den Photoinitiatoren oder Sensitizern entstehen. Zudem muss die Anordnung durchlässig für UV-Licht sein.

Weitere strahlenhärtende Flüssigkleber auf elastomerer Basis werden in folgenden Schriften offenbart:

Eine strahlungshärtende Klebmasse auf unterschiedlicher chemischer Basis hauptsächlich Acrylaten und acrylatmodifizierten Elastomeren für opto-elektronische Bauteile wird in der WO 2006/107748 beschrieben, wobei hier zur Verbesserung der Wasserdampfbarriere Wasserabsorber zugesetzt werden.

Eine weitere strahlungshärtende Klebmasse auf ähnlicher chemischer Basis, insbesondere mit acrylatmodifizierten Polyisobutylenen wird in der WO 2007/111607, beschrieben

Hier wird zwar der Nachteil der geringen Flexibilität vermindert, doch bleiben alle weiteren oben genannten Nachteile reaktiver Flüssigkleber bestehen.

Da Bestandteile insbesondere organischer Elektronik und viele der eingesetzten Polymere häufig empfindlich gegen UV-Belastung sind, ist ein länger andauernder Außeneinsatz nicht ohne weitere zusätzliche Schutzmaßnahmen, etwa weitere Deckfolien möglich. Diese können bei UV-härtenden Klebesystemen erst nach der UV-Härtung aufgebracht werden, was die Komplexität der Fertigung und die Dicke der Anordnung zusätzlich erhöht.

Bekannt sind auch Haftklebebänder zur Kapselung elektronischer Anordnungen (z.B. US 2006/0100299 A1, WO 2007/087281 A1, US 2005/0227082, DE 102008047964, DE 102008060113)

Die US 2006/0100299 A1 offenbart ein UV-härtbares Haftklebeband zur Kapselung einer elektronischen Anordnung. Das Haftklebeband umfasst eine Klebemasse auf Basis einer Kombination eines Polymers mit einem Erweichungspunkt von größer 60°C, eines polymerisierbaren Epoxidharzes mit einem Erweichungspunkt von unter 30°C und einem Photoinitiator. Bei den Polymeren kann es sich um Polyurethan, Polyisobutylen, Polyacrylnitril, Polyvinylidenchlorid, Poly(meth)acrylat oder Polyester, insbesondere aber um ein Acrylat handeln. Des Weiteren sind Klebharze, Weichmacher oder Füllstoffe enthalten.

Acrylatmassen haben eine sehr gute Beständigkeit gegenüber UV-Strahlung und verschiedenen Chemikalien, besitzen aber sehr unterschiedliche Klebkräfte auf verschiedenen Untergründen. Während die Klebkraft auf polaren Untergründen wie Glas oder Metall sehr hoch ist, ist die Klebkraft auf unpolaren Untergründen wie beispielsweise Polyethylen oder Polypropylen eher gering. Hier besteht die Gefahr der Diffusion an der Grenzfläche in besonderem Maße. Zudem sind diese Massen sehr polar, was eine Diffusion insbesondere von Wasserdampf, trotz nachträglicher Vernetzung, begünstigt. Durch den Einsatz polymerisierbarer Epoxidharze wird diese Tendenz weiter verstärkt.

Die in US 2006/0100299 genannte Ausführung als Haftklebemasse hat den Vorteil einer einfachen Applikation, leidet aber ebenfalls unter möglichen Spaltprodukten durch die enthaltenen Photoinitiatoren, einer zwangsläufigen UV-Durchlässigkeit des Aufbaus und einer Verringerung der Flexibilität nach der Aushärtung. Zudem ist durch den geringen Anteil an Epoxidharzen oder anderen Vernetzern, der für eine Erhaltung der Haftklebrigkeit und insbesondere der Kohäsion notwendig ist, eine nur sehr viel geringere Vernetzungsdichte als mit Flüssigklebern erreichbar.

Die WO 2007/087281 A1 offenbart ein transparentes flexibles Haftklebeband auf Basis von Polyisobutylen (PIB) für elektronische Anwendungen, insbesondere OLED. Dabei wird Polyisobutylen mit einem Molekulargewicht von mehr als 500.000 g/mol und ein hydriertes cyclisches Harz verwendet. Optional ist der Einsatz eines photopolymerisierbaren Harzes und eines Photoinitiators möglich.

Klebemassen auf der Basis von Polyisobutylen weisen aufgrund ihrer geringen Polarität eine gute Barriere gegen Wasserdampf auf, haben aber selbst bei hohen Molekulargewichten eine relativ geringe Kohäsivität, weshalb sie bei erhöhten Temperaturen häufig eine geringe Scherfestigkeit aufweisen. Der Anteil an niedermolekularen Bestandteilen kann nicht beliebig reduziert werden, da sonst die Haftung deutlich verringert wird und die Grenzflächenpermeation zunimmt. Bei Einsatz eines hohen Anteils an funktionellen Harzen, der aufgrund der sehr geringen Kohäsion der Masse notwendig ist, wird die Polarität der Masse wieder erhöht und damit der Löslichkeits-Term vergrößert.

Beschrieben sind weiterhin Barriereklebmassen auf der Basis von Styrolblockcopolymeren, möglichst hydrierten und entsprechend hydrierten Harzen, DE 102008047964.

Durch die Bildung von zumindest zwei Domänen innerhalb des Blockcopolymers erhält man zusätzlich eine sehr gute Kohäsion bei Raumtemperatur und gleichzeitig verbesserte Barriereeigenschaften.

Haftklebebänder benötigen in der Regel durch die relativ hochmolekularen Polymere im Gegensatz zu Flüssigklebstoffen für eine gute Benetzung und Haftung auf der Oberfläche eine gewisse Zeit, ausreichenden Druck und eine gute Balance zwischen viskosem Anteil und elastischen Anteil. Weiterhin zeigen Haftklebmassen, insbesondere solche auf der Basis von Polyisobutylen als auch solche auf Basis von Styrolblockcopolymeren einen bedeutenden Nachteil: Bei einer Verklebung zwischen zwei Folien, die mit einer Barriereschicht versehen sind, z.B. zwei PET-Folien mit einer SiOx-Beschichtung, wie sie z.B. für organische Solarzellen eingesetzt werden kann, kommt es bei einer Lagerung in der Feuchte und Wärme zu einer starken Blasenbildung. Auch ein vorheriges Trocknen der Folien und/oder oder Klebemasse kann diese Blasenbildung nicht verhindern.

Aus dem Stand der Technik ist zudem eine Haftklebemasse ohne Barriereeigenschaften bekannt (WO 03/065470 A1), die in einem elektronischen Aufbau als Transferklebemasse verwendet wird. Die Klebmasse enthält einen funktionellen Füllstoff, der mit Sauerstoff oder Wasserdampf innerhalb des Aufbaus reagiert. Damit ist eine einfache Applikation eines Scavengers innerhalb des Aufbaus möglich. Für die Versiegelung des Aufbaus nach Außen wird ein weiteres Adhäsiv mit geringer Durchlässigkeit verwendet.

Weiterhin bekannt sind Heißschmelzklebemassen zur Verkapselung elektronischer Aufbauten. Vielfach werden hier Copolymere des Ethylens eingesetzt, z.B. Ethylen-Ethylacetat (EEA), Ethylen-Acrylsäure-Copolymer (EAA), Ethylen-Butylacrylat (EBA) oder Ethylen-Methylacrylat (EMA). Insbesondere für Solarzellenmodule basierend auf Siliziumwafern werden in der Regel vernetzende Ethylen-Vinylacetat-(EVA)-Copolymere eingesetzt. Die Vernetzung findet dabei während des Versiegelungsprozesses unter Druck und bei Temperaturen oberhalb von etwa 120 °C statt. Dieser Prozess ist für viele auf organischen Halbleitern basierenden oder in Dünnschichtverfahren hergestellten (opto-)elektronischen Aufbauten aufgrund der hohen Temperaturen oder der mechanischen Belastung durch den Druck nachteilig. In JP2002260847 wird dieser Prozess aber auch für organische Leuchtdioden aufgezeigt.

Weitere vernetzende oder nicht vernetzende Heißschmelzklebemassen auf der Basis von Blockcopolymeren oder funktionalisierten Polymeren sind in US5488266, WO2008/036707 A2, WO 2003/002684, JP2008004561, JP2005298703 und US 20040216778 beschrieben.

Desweiteren wird in WO 2009/085736 A2 ein Heißschmelzkleber für die Randversiegelung von Solarzellen beschrieben, in den ein Desiccant eingearbeitet ist. Als Basispolymer wird beispielhaft ein Polyisobutylen und ein 1-Buten Copolymer verwendet. In bestimmten Ausführungen werden vernetzende Polymere verwendet.
Es ist eine WVTR von 3 g/m$^2$*d angegeben, jedoch wird nicht auf die Dicke der Schicht eingegangen. Zudem wird der Schmelzkleber in flüssiger Form aufgebracht und bei hohen Temperaturen von 160°C verarbeitet.

Ein ähnlicher Ansatz wird in US 4633032 aufgezeigt. Für die Randversiegelung eines Solarmoduls wird ein Hotmelt-Butylkautschuk - beispielhaft PIB - verwendet, aber nicht genauer spezifiziert.

US2003/143423 A1 offenbart ein Verfahren zur Kapselung einer elektronischen Anordnung mit einer Klebmasse hergestellt aus Styrol enthaltende Blockcopolymere.

WO2008/043660 A1 beschreibt eine Heißschmelzklebmasse auf Basis von säure- oder säureanhydridmodifizierten Vinylaromatenblockcopolymeren.

Nachteilig an den im Stand der Technik verwendeten Heißschmelzklebemassen ist, dass bei nicht vorhandener Vernetzung die Barrierewirkung geringer ist, insbesondere die Barriere gegen Sauerstoff, sowie die Kohäsion der Klebemasse bei höheren Temperaturen stark abfällt. Dadurch ist auch die Gefahr der Blasenbildung bei der Lagerung des Aufbaus in der Feuchte und Wärme erhöht. Wird die Klebemasse thermisch vernetzt, sind in der Regel Temperaturen notwendig, die die Gefahr einer Schädigung des elektronischen Aufbaus bergen. Strahlenvernetzende Heißschmelzklebemassen bergen wiederum den Nachteil der möglichen Strahlenschädigung des elektronischen Aufbaus und der Notwendigkeit der Strahlendurchlässigkeit eines Teils des Aufbaus.
Viele der beschriebenen Heißschmelzkleber liegen zudem nicht als einfach zu verarbeitendes flächiges Substrat vor, sondern müssen bei hohen Temperaturen von über 120°C flüssig aufgetragen werden.

Aufgabe der vorliegenden Erfindung ist es, ein Verfahren zur Kapselung einer elektronischen Anordnung gegen Permeanten, insbesondere Wasserdampf und Sauerstoff, anzugeben, dass einfach durchführbar ist und mit dem gleichzeitig eine gute Kapselung erzielt wird und keine Blasen bei Verklebung zwischen zwei Polyesterfolien mit Barriereschicht und Lagerung bei 85°C und 85%rF gebildet werden. Ferner soll die Lebensdauer von (opto-) elektronischen Anordnungen durch die Verwendung einer geeigneten, insbesondere flexiblen, Klebemasse erhöht werden.

Die vorliegende Erfindung löst das zuvor beschriebene Problem durch ein Verfahren gemäß Anspruch 1. Nebengeordnete Lösungen beschreiben die Patentansprüche 5 und 24. Bevorzugte Ausgestaltungen und Weiterbildungen sind Gegenstand der jeweiligen Unteransprüche.

Demgemäß betrifft der Hauptanspruch ein Verfahren zur Kapselung einer elektronischen Anordnung gegen Permeanten, bei dem eine zumindest teilweise vernetzte Heißschmelzklebmasse auf Basis von säure- oder säureanhydridmodifizierten Vinylaromatenblockcopolymeren bereitgestellt wird und bei dem die Heißschmelzklebemasse auf und/oder um die zu kapselnden Bereiche der elektronischen Anordnung appliziert wird.

Als Permeanten im Sinne der vorliegenden Schrift werden solche chemischen Substanzen (zum Beispiel Atome, Ionen, Moleküle, ...) bezeichnet, die in eine Anordnung bzw. ein Bauteil, insbesondere eine elektronische oder opto-elektronische Anordnung oder ein entsprechendes Bauteil, eindringen können und hier insbesondere zu Funktionsstörungen führen können. Das Eindringen kann beispielsweise durch das Gehäuse oder die Ummantelung selbst erfolgen, insbesondere aber auch durch Öffnungen im Gehäuse bzw. der Ummantelung oder durch Nahtstellen, Verklebungsstellen, Schweißstellen oder dergleichen. Als Gehäuse bzw. Ummantelung in diesem Sinne werden die Bauteile verstanden, die die empfindlichen Bauteile ganz oder teilweise umschließen und neben ihrer mechanischen Funktion insbesondere zu deren Schutz vorgesehen sind.

Permeanten im Sinne der vorliegenden Schrift sind insbesondere niedermolekulare organische oder anorganische Verbindungen, zum Beispiel Wasserstoff ($H_2$), ganz besonders Sauerstoff ($O_2$) und Wasser ($H_2O$). Die Permeanten können insbesondere gasförmig oder in Dampfform vorliegen.

Auf die Ausführungen im einführenden Teil wird hiermit Bezug genommen.

Die vorliegende Erfindung beruht zunächst auf der überraschenden Erkenntnis, dass auch bereits vor der Applikation vernetzte Heißschmelzklebemassen weiterhin durch ein Heißsiegelverfahren verarbeitet werden können und dabei genügend Haftung entwickeln, um eine wirksame Verkapselung eines elektronischen Aufbaus zu ermöglichen. Es hat sich nämlich gezeigt, dass eine zumindest teilweise vernetzte Heißschmelzklebemasse auf Basis von Vinylaromatenblockcopolymeren zur Kapselung elektronischer Anordnungen besonders geeignet ist. Erfindungsgemäß wird entsprechend eine Heißschmelzklebemasse auf Basis von vernetzbaren Vinylaromatenblockcopolymeren bereitgestellt und unter Erwärmung auf die zu kapselnden Bereiche der elektronischen Anordnung appliziert. Je nach Ausgestaltung der Heißschmelzklebemasse ist keine nachfolgende Behandlung mehr erforderlich.

Eine Heißschmelzklebemasse auf Basis von Vinylaromatenblockcopolymeren bedeutet insbesondere eine Heißschmelzklebemasse, bei der der Gesamtanteil der Blockcopolymere mindestens 40 Gew.-% beträgt, bevorzugt mindestens 55 Gew.-%.

Eine zumindest teilweise Vernetzung bedeutet, dass zumindest ein Teil der für eine Vernetzung zur Verfügung stehenden chemischen Gruppen auch tatsächlich für eine Vernetzung umgesetzt wurde.

Als Kapselung wird vorliegend nicht nur ein vollumfänglicher Einschluss mit der genannten Haftklebemasse bezeichnet sondern auch bereits eine bereichsweise Applikation der Heißschmelzklebemasse auf den zu kapselnden Bereichen der (opto)-elektronischen Anordnung, beispielsweise eine einseitige Überdeckung oder eine Umrahmung einer elektronischen Struktur.

Durch die Auswahl der Bestandteile der Heißschmelzklebemasse und die dadurch geringe Polarität resultierend aus einem unpolaren Block des Vinylaromatenblockcopolymeren und dem daraus resultierenden niedrigen Löslichkeits-Term (S) des Diffusionskoeffizienten wird ein niedriges Durchtrittvermögen von Permeanten wie Wasserdampf und Sauerstoff erreicht, insbesondere aber von Wasserdampf. Durch die Bildung von zumindest zwei Domänen innerhalb des Blockcopolymers erhält man zusätzlich eine sehr gute Kohäsion und gleichzeitig verbesserte Barriereeigenschaften. Diese Domänenbildung wird oft auch als "physikalische Vernetzung" bezeichnet, soll aber hier nicht unter den Begriff "Vernetzung" gerechnet werden. Durch entsprechend chemisch modifizierte und/oder weitere Komponenten, wie nachfolgend beschrieben, werden je nach Anforderungen der (opto)elektronischen Anordnung, durch eine Vernetzungsreaktion die Eigenschaften vorteilhaft an die Anforderungen angepasst, wobei zumindest ein Teil der Vernetzung bereits vor der Applikation der Heißschmelzklebemasse stattfindet.

Vorteil der hier vorliegenden Erfindung ist also, im Vergleich zu Haftklebemassen, die Kombination aus sehr guten Barriereeigenschaften gegenüber Sauerstoff und vor allem gegenüber Wasserdampf bei gleichzeitiger guter Grenzflächenhaftung auf unterschiedlichen Substraten, guten kohäsiven Eigenschaften, auch bei Temperaturen über dem Erweichungsbereich der Styroldomänen durch eine im folgenden beschriebene Vernetzungsreaktion und, im Vergleich zu Flüssigklebstoffen, eine sehr hohe Flexibilität und eine einfache Applikation in der (opto-)elektronischen Anordnung und bei/in der Kapselung. Im Vergleich zu anderen Heißschmelzklebemassen zeichnen sie sich durch eine niedrige Applikationstemperatur bei gleichzeitig gegebener Temperaturbeständigkeit aus. Je nach Ausführung der Heißschmelzklebemasse bieten Klebemassen auf Basis von vernetzten Vinylaromatenblockcopolymeren eine gute Beständigkeit gegenüber Chemikalien und Umwelteinflüssen. Des Weiteren liegen in bestimmten Ausführungen auch transparente Klebemassen vor, die in besonderer Weise für den Einsatz in (opto-)elektronischen Anordnungen Anwendung finden können, da eine Verminderung von einfallendem oder austretendem Licht sehr gering gehalten wird.

Die Heißschmelzklebemasse auf Basis von vernetzten Vinylaromatenblockcopolymeren zeichnet sich also, neben guter Verarbeitbarkeit und Beschichtbarkeit, durch gute Produkteigenschaften in Bezug auf Adhäsion und Kohäsion aus sowie durch eine gute Barrierewirkung gegenüber Sauerstoff und eine sehr gute Barrierewirkung gegenüber Wasserdampf aus, insbesondere im Vergleich zu Heißschmelzklebemassen auf Basis von Acrylaten, Nitril- oder Chloroprenkautschuken oder Ethylen-Vinylacetat-Copolymeren. Eine derartige Heißschmelzklebemasse kann auf einfache Weise in eine elektronische Anordnung integriert werden, insbesondere auch in solche Anordnung, die hohe Flexibilität erfordert. Weitere besonders vorteilhafte Eigenschaften der Heißschmelzklebemasse sind ähnlich gute Haftung auf unterschiedlichen Substraten, hohe Scherfestigkeit und hohe Flexibilität. Durch eine sehr gute Haftung am Substrat wird zudem auch eine geringe Grenzflächenpermeation erzielt. Durch die Verwendung der hier beschriebenen Formulierungen für die Verkapselung von (opto-)elektronischen Strukturen werden vorteilhafte Anordnungen gewonnen, die die oben genannten Vorteile vereinen, den Verkapselungsprozess dadurch beschleunigen und vereinfachen sowie die Produktqualität erhöhen.

Da in bestimmten Ausführungen der Heißschmelzklebemasse nach der Applikation keine weiteren thermischen Prozessschritte oder Bestrahlung notwendig sind, kein Schrumpf durch eine nach der Applikation ausgeführte Vernetzungsreaktion beim Aufbau des (opto-) elektronischen Aufbaus auftritt und die Heißschmelzklebemasse als bahnförmiges Material oder in einer der elektronischen Anordnung entsprechend angepassten Form vorliegt, kann die Masse einfach und schnell unter geringem Druck und geringer Temperatur in den Verkapselungsprozess des (opto-)elektronischen Aufbaus integriert werden. Die üblicherweise mit den vermiedenen Verarbeitungsschritten einhergehenden Nachteile, wie thermische und mechanische Belastungen, können so minimiert werden. Eine Verkapselung durch Lamination von zumindest Teilen der (opto-)elektronischen Aufbauten mit einem flächigen Barrierematerial (z.B. Glas, insbesondere Dünnglas, metalloxidbeschichteten Folien, Metallfolien, Multilayer-Substratmaterialien) ist mit sehr guter Barrierewirkung in einem einfachen Rolle-zu-Rolle Prozess möglich. Die Flexibilität des gesamten Aufbaus hängt, neben der Flexibilität der Heißschmelzklebemasse von weiteren Faktoren, wie Geometrie und Dicke der (opto-)elektronischen Aufbauten bzw. der flächigen Barrierematerialien ab. Die hohe Flexibilität der Heißschmelzklebemasse ermöglicht es aber sehr dünne, biegsame und flexible (opto-) elektronische Aufbauten zu realisieren. Unter dem benutzten Begriff "biegsam" ist die Eigenschaft zu verstehen, dass der Krümmung eines gebogenen Gegenstands wie einer Trommel mit bestimmtem Radius, insbesondere mit einem Radius von 1 mm, ohne Beschädigung gefolgt wird.

Von besonderem Vorteil für die Kapselung von (opto-)elektronischen Aufbauten ist es, dass die zumindest teilweise vernetzte erfindungsgemäße Heißschmelzklebemasse bei geringer Temperatur appliziert werden kann. Vorteilhaft beträgt die Temperatur weniger als 120°C Als optimaler Temperaturbereich haben sich Temperaturen zwischen 80°C und 100°C herausgestellt.

In bevorzugter Ausgestaltung eines Verfahrens zur Kapselung einer elektronischen Anordnung gegen Permeanten kann die Heißschmelzklebemasse in Form eines Klebebandes bereitgestellt werden. Diese Darreichungsart erlaubt eine besonders einfache und gleichmäßige Applikation der Heißschmelzklebemasse.

Der allgemeine Ausdruck "Klebeband" umfasst dabei in einer Ausführungsform ein Trägermaterial, welches ein- oder beidseitig mit einer Heißschmelzklebemasse versehen ist. Das Trägermaterial umfasst alle flächigen Gebilde, beispielsweise in zwei Dimensionen ausgedehnte Folien oder Folienabschnitte, Bänder mit ausgedehnter Länge und begrenzter Breite, Bandabschnitte, Stanzlinge. Mehrschichtanordnungen und dergleichen. Dabei sind für verschiedene Anwendungen unterschiedlichste Träger, wie z.B. Folien, Gewebe, Vliese und Papiere mit den Klebmassen kombinierbar. Des Weiteren umfasst der Ausdruck "Klebeband" auch so genannte "Transferklebebänder" oder "hitzeaktivierbare Folien" d.h. ein Klebeband ohne Träger. Bei einem Transferklebeband ist die Klebemasse vielmehr vor der Applikation zwischen flexiblen Linern, die mit einer Trennschicht versehen sind und/oder anti-adhäsive Eigenschaften aufweisen, aufgebracht. Zur Applikation wird regelmäßig zunächst ein Liner entfernt, die Klebmasse appliziert und dann der zweite Liner entfernt. Bei einer hitzeaktivierbaren Folie fehlen auch diese Liner oder ein solcher liegt nur auf einer Seite vor. Die Heißschmelzklebemasse kann so direkt zur Verbindung zweier Oberflächen in (opto)elektronischen Anordnungen verwendet werden.

Als Trägermaterial eines Klebebandes werden vorliegend bevorzugt Polymerfolien, Folienverbunde oder mit organischen und/oder anorganischen Schichten versehene Folien oder Folienverbunde eingesetzt. Derartige Folien / Folienverbunde können aus allen gängigen zur Folienherstellung verwendeten Kunststoffen bestehen, beispielhaft aber nicht einschränkend erwähnt seien:

Polyethylen, Polypropylen - insbesondere das durch mono-oder biaxiale Streckung erzeugte orientierte Polypropylen- (OPP), Cyclische Olefin Copolymere (COC), Polyvinylchlorid (PVC), Polyester - insbesondere Polyethylenterephthalat (PET) und Poylethylennaphtalat (PEN), Ethylenvinylalkohol (EVOH), Polyvinylidenchlorid (PVDC), Polyvinylidenfluorid (PVDF), Polyacrylnitril (PAN), Polycarbonat (PC), Polyamid (PA), Polyethersulfon (PES) oder Polyimid (PI).

Der Träger kann zudem mit organischen oder anorganischen Beschichtungen oder Schichten kombiniert sein. Dies kann durch übliche Verfahren, wie z.B. Lackieren, Drucken, Bedampfen, Sputtern, Co-Extrusion oder Lamination geschehen. Beispielhaft, aber nicht einschränkend erwähnt seien hier etwa Oxide oder Nitride des Siliciums und des Aluminiums, Indium-Zinn-Oxid (ITO) oder Sol-Gel-Beschichtungen.

Besonders bevorzugt sind diese Folien / Folienverbunde, insbesondere die Polymerfolien, mit einer Permeationsbarriere für Sauerstoff und Wasserdampf versehen, wobei die Permeationsbarriere die Anforderungen für den Verpackungsbereich übertrifft (WVTR < $10^{-1}$ g/(m$^2$d); OTR < $10^{-1}$ cm$^3$/(m$^2$d bar)). Die Bestimmung der Permeabilität für Sauerstoff (OTR) und Wasserdampf (WVTR) erfolgt nach DIN 53380 Teil 3 bzw. ASTM F-1249. Die Sauerstoffdurchlässigkeit wird bei 23°C und einer relativen Feuchte von 50% gemessen. Die Wasserdampfdurchlässigkeit wird bei 37,5°C und einer relativen Feuchte von 90% bestimmt. Die Ergebnisse werden auf eine Foliendicke von 50 μm normiert.

Zudem können die Folien / Folienverbunde in bevorzugter Ausgestaltung transparent ausgebildet sein, damit auch der Gesamtaufbau eines derartigen Klebeartikels transparent ausgebildet ist. "Transparenz" bedeutet dabei eine mittlere Transmission im sichtbaren Bereich des Lichts von mindestens 75%, bevorzugt höher als 90%.

Je nach Anforderungen der (opto-)elektronischen Anordnung können in einer bestimmten Ausführung der Heißschmelzklebemasse die elastischen und viskosen Eigenschaften, sowie die Barrierewirkung auch zusätzlich durch eine nachträgliche Vernetzungsreaktion variiert werden. Dies kann angepasst an die (opto-)elektronische Anordnung sowohl thermisch, als auch durch elektromagnetische Strahlung, bevorzugt aber durch UV-Strahlung, Elektronenstrahlung oder Gammastrahlung stattfinden. Damit kann die Barrierewirkung wie auch die Klebfestigkeit nach dem Einbringen in den (opto-) elektronischen Aufbau gesteigert werden. Dabei bleibt aber die hohe Flexibilität der Heißschmelzklebemasse in der Regel erhalten.

Weiter bevorzugt kommt eine Heißschmelzklebemasse zum Einsatz, die in bestimmten Ausführungen im sichtbaren Licht des Spektrums (Wellenlängenbereich von etwa 400 nm - 800 nm) transparent ist. Für bestimmte Anwendungen, etwa bei Solarzellen kann dieser Bereich aber auch auf definierte UV oder IR-Regionen erweitert werden. Die gewünschte Transparenz im bevorzugten Bereich des sichtbaren Spektrums lässt sich insbesondere durch die Verwendung farbloser Klebharze erzielen. Eine derartige Heißschmelzklebemasse eignet sich somit auch für einen vollflächigen Einsatz über einer (opto-) elektronischen Struktur. Eine vollflächige Verklebung bietet, bei einer etwa mittigen Anordnung der elektronischen Struktur gegenüber einer Randversiegelung den Vorteil, dass der Permeant durch die gesamte Fläche diffundieren müsste, bevor er die Struktur erreicht. Der Permeationsweg ist somit deutlich erhöht. Die in dieser Ausführungsform verlängerten Permeationswege im Vergleich zur Randversiegelung etwa durch Flüssigklebstoffe wirken sich positiv auf die Gesamtbarriere aus, da der Permeationsweg umgekehrt proportional zur Durchlässigkeit ist.

"Transparenz" bedeutet dabei eine mittlere Transmission der Klebemasse im sichtbaren Bereich des Lichts von mindestens 75%, bevorzugt höher als 90%. Bei der Ausführung als Heißschmelzklebeband mit Träger hängt die die maximale Transmission des gesamten Aufbaus zudem von der Art des verwendeten Trägers und der Art des Aufbaus ab.

Die elektronischen Strukturen (opto-)elektronischer Anordnungen sind oftmals anfällig gegenüber UV-Strahlung. Als besonders vorteilhaft hat sich daher herausgestellt, wenn die Heißschmelzklebemasse zudem UV-blockend ausgebildet ist. Unter dem Begriff "UV-blockend" wird vorliegend ein mittlerer Transmissionsgrad von maximal 20%, vorzugsweise von maximal 10%, weiter bevorzugt von maximal 1 % im entsprechenden Wellenlängenbereich bezeichnet. In bevorzugter Ausgestaltung ist die Heißschmelzklebemasse im Wellenlängenbereich von 320 nm bis 400 nm (UVA-Strahlung) UV-blockend ausgebildet, vorzugsweise im Wellenlängenbereich von 280 nm bis 400 nm (UVA- und UVB-Strahlung), weiter vorzugsweise im Wellenlängenbereich von 190 nm bis 400 nm (UVA-, UVB- und UVC-Strahlung).

Die UV-blockende Wirkung der Heißschmelzklebemasse kann insbesondere durch eine Zugabe von UV-Blockern oder geeigneten Füllstoffen zur Heißschmelzklebemasse erzielt werden. Als UV-Blocker eignen sich beispielsweise HALS (Hindert Armine Light Stabilizer) wie Tinuvin der Firma Ciba oder Benzimidazolderivate. Als Füllstoff ist besonders Titandioxid geeignet, ganz besonders nanoskaliges Titandioxid, da hierdurch eine Transparenz im sichtbaren Bereich beibehalten werden kann.

In einer weiteren vorteilhaften Ausführung zeigt die Heißschmelzklebemasse eine sehr gute Beständigkeit gegen Witterungseinflüsse und UV-Licht. Diese Beständigkeit kann insbesondere durch Verwendung von hydrierten Elastomeren und/oder hydrierten Harzen erzielt werden.

Als Klebemassen finden bevorzugt solche auf Basis von Blockcopolymeren enthaltend Polymerblöcke überwiegend gebildet von Vinylaromaten (A-Blöcke), bevorzugt Styrol, und solche überwiegend gebildet durch Polymerisation von 1,3-Dienen (B-Blöcke), bevorzugt Butadien, Isopren oder einer Mischung aus beiden Monomeren, Verwendung. Diese B-Blöcke weisen üblicherweise eine geringe Polarität auf. Sowohl Homo- als auch Copolymerblöcke sind als B-Blöcke bevorzugt nutzbar.

Die aus den A- und B-Blöcken resultierenden Blockcopolymere können gleiche oder unterschiedliche B-Blöcke enthalten, die teilweise, selektiv oder vollständig hydriert sein können. Die Blockcopolymere können lineare A-B-A Strukturen aufweisen. Einsetzbar sind ebenfalls Blockcopolymere von radialer Gestalt sowie sternförmige und lineare Multiblockcopolymere. Als weitere Komponenten können A-B Zweiblockcopolymere vorhanden sein. Blockcopolymere von Vinylaromaten und Isobutylen sind ebenfalls erfindungsgemäß einsetzbar. Sämtliche der vorgenannten Polymere können alleine oder im Gemisch miteinander genutzt werden.

Verwendet werden können auch Blockcopolymere, die neben den oben beschriebenen Blöcken A und B zumindest einen weiteren Block enthalten, wie z.B. A-B-C-Blockcoplymere.

Denkbar, aber nicht Gegenstand der vorliegenden Erfindung ist auch die Verwendung der oben genannten B-Blöcke mit A-Blöcken von anderer chemischer Natur, die eine Glasübergangstemperatur oberhalb der Raumtemperatur zeigen, wie zum Beispiel Polymethyl methacrylat.

In einer vorteilhaften Ausführungsform weisen die Blockcopolymere einen Polyvinylaromatenanteil von 10 Gew.-% bis 35 Gew.-% auf.

In einer weiteren bevorzugten Ausgestaltung beträgt der Anteil der Vinylaromatenblockcopolymere in Summe bezogen auf die gesamte Heißschmelzklebmasse mindestens 50 Gew.-%, vorzugsweise mindestens 70 Gew.-%, weiter bevorzugt mindestens 80 Gew.-%. Ein zu geringer Anteil an Vinylaromatenblockcopolymere hat zur Folge, dass die Kohäsion der Heißschmelzklebemasse relativ niedrig ist oder die Klebmasse haftklebrig wird. Der maximale Anteil der Vinylaromatenblockcopolymere in Summe bezogen auf die gesamte Heißschmelzklebmasse beträgt maximal 100 Gew.-%,

Zumindest ist ein Teil der eingesetzten Blockcopolymere dabei säure- oder säureanhydridmodifiziert, wobei die Modifizierung hauptsächlich durch radikalische Pfropfcopolymerisation von ungesättigten Mono- und Polycarbonsäuren oder -säureanhydriden, wie z.B. Fumarsäure, Itaconsäure, Citraconsäure, Acrylsäure, Maleinsäureanhydrid, Itaconsäureanhydrid oder Citraconsäureanhydrid, bevorzugt Maleinsäureanhydrid erfolgt. Bevorzugt liegt der Anteil an Säure bzw. Säureanhydrid zwischen 0,5 und 4 Gewichtsprozenten bezogen auf das gesamte Blockcopolymer.

Die Vernetzung dieser Elastomere kann auf unterschiedliche Weise erfolgen.

Zum einen können die Säure- bzw. Säureanhydridgruppen mit Vernetzern reagieren, wie z.B. verschiedenen Aminen oder Epoxidharzen.

Als Amine können dabei primäre und sekundäre Amine aber auch Amide und andere Stickstoffhaltige Verbindung mit einem Wasserstoff direkt am Stickstoff gebunden, zum Einsatz kommen.

Als Epoxidharze werden üblicherweise sowohl monomere als auch oligomere Verbindungen mit mehr als einer Epoxidgruppe pro Molekül verstanden. Dieses können Reaktionsprodukte von Glycidestern oder Epichlorhydrin mit Bisphenol A oder Bisphenol F oder Mischungen aus diesen beiden sein. Einsetzbar sind ebenfalls Epoxidnovolakharze gewonnen durch Reaktion von Epichlorhydrin mit dem Reaktionsprodukt aus Phenolen und Formaldehyd. Auch monomere Verbindungen mit mehreren Epoxidendgruppen, die als Verdünner für Epoxidharze eingesetzt werden sind verwendbar. Ebenfalls sind elastisch modifizierte Epoxidharze einsetzbar oder epoxidmodifizierte Elastomere wie z.B. epoxidierte Styrolblockcopolymere, z.B. Epofriend der Fa. Daicel.

Beispiele von Epoxidharzen sind AralditeTM 6010 , CY-281TM, ECNTM 1273, ECNTM 1280, MY 720, RD-2 von Ciba Geigy, DERTM 331, 732, 736, DENTM 432 von Dow Chemicals, EponTM 812, 825, 826, 828, 830 etc. von Shell Chemicals, HPTTM 1071, 1079 ebenfalls von Shell Chemicals, BakeliteTM EPR 161, 166, 172, 191, 194 etc. der Bakelite AG.

Kommerzielle aliphatische Epoxidharze sind z.B. Vinylcyclohexandioxide wie ERL-4206, 4221, 4201, 4289 oder 0400 von Union Carbide Corp.

Elastifizierte Elastomere sind erhältlich von der Fa. Noveon unter dem Namen Hycar.

Epoxidverdünner, monomere Verbindungen mit mehreren Epoxidgruppen sind z.B. BakeliteTM EPD KR, EPD Z8, EPD HD, EPD WF, etc. der Bakelite AG oder PolypoxTM R 9, R12, R 15, R 19, R 20 etc. der Fa. UCCP.

Üblicherweise wird bei diesen Reaktionen auch ein Beschleuniger eingesetzt. Dieser kann z.B. aus der Gruppe der tertiären Amine oder modifizierten Phosphine, wie z.B. Triphenylphosphin, kommen.

Während die Reaktion mit den Aminen häufig schon bei Raumtemperatur stattfindet, läuft die Vernetzung mit den Epoxidharzen im Allgemeinen unter erhöhter Temperatur ab.

Die zweite Möglichkeit der Vernetzung erfolgt über Metallchelate.

Eine Vernetzung von maleinsäureanhydridmodifizierten Blockcopolymeren mit Metallchelaten ist bekannt aus EP 1311559 B1, bei der eine Steigerung der Kohäsion der Blockcopolymermischungen beschrieben wird. Die Verwendung in (opto-) elektronischen Aufbauten ist hingegen nicht erwähnt.

Die Metalle der Metallchelate können die der 2. 3. 4. und 5. Hauptgruppe und die Übergangsmetalle sein. Besonders geeignet sind z.B. Aluminium, Zinn, Titan, Zirkonium, Hafnium, Vanadium, Niob, Chrom, Mangan, Eisen, Kobalt, und Cer. Besonders bevorzugt sind Aluminium und Titan.

Für die Chelatvernetzung können unterschiedliche Metallchelate zum Einsatz kommen, die durch die folgende Formel wiedergegeben werden können:

$$(R_1O)_n \, M \, (XR_2Y)_m,$$

wobei

M ein Metall wie oben beschrieben ist;
$R_1$ eine Alkyl- oder Arylgruppe wie Methyl, Ethyl, Butyl, Isopropyl oder Benzyl ist;
n null oder eine größere ganze Zahl ist,
X und Y Sauerstoff oder Stickstoff sind, die jeweils auch durch eine Doppelbindung an R2 gebunden sein können;
$R_2$ eine X und Y verbindende Alkylengruppe ist, die verzweigt sein kann, oder auch Sauerstoff oder weitere Heteroatome in der Kette enthalten kann;
m eine ganze Zahl, mindestens jedoch 1 ist.

Bevorzugte Chelatliganden sind solche, die aus der Reaktion folgender Verbindungen entstanden sind: Triethanolamin, 2,4-Pentandion, 2-Ethyl-1,3-Hexandiol oder Milchsäure Besonders bevorzugte Vernetzer sind Aluminium- und Titanylacetylacetonate.

Dabei sollte ein annähernd äquivalentes Verhältnis zwischen den Säure- bzw. Säureanhydridgruppen und den Acetylacetonatgruppen gewählt werden, um eine optimale Vernetzung zu erreichen, wobei sich ein kleiner Überschuss an Vernetzer als positiv herausgestellt hat.

Das Verhältnis zwischen Anhydridgruppen und Acetylacetonatgruppen kann aber variiert werden, dabei sollte für eine ausreichende Vernetzung keine der beiden Gruppen in mehr als einem fünffachen molaren Überschuss vorliegen.

Überraschenderweise zeigen auch Heißschmelzklebmassen die mit Chelaten vernetzte mit Säure oder Säureanhydrid modifizierte Vinylaromatenblockcopolymere enthalten eine sehr niedrige Wasserdampf- bzw. Sauerstoff-Durchlässigkeit. Dieses konnte von einer Heißschmelzklebemasse mit solch polaren Bestandteilen wie Säureanhydriden und Metallchelaten nicht erwartet werden.

In weiter bevorzugter Ausgestaltung weist die Heißschmelzklebemasse neben dem mindestens einen Vinylaromatenblockcopolymer mindestens ein Klebharz auf, um die Adhäsion in gewünschter Weise zu erhöhen. Das Klebharz sollte mit dem Elastomerblock der Blockcopolymere verträglich sein.

Als Klebrigmacher können in der Heißschmelzklebemasse zum Beispiel nicht hydrierte, partiell oder vollständig hydrierte Harze auf Basis von Kolophonium und Kolophoniumderivaten, hydrierte Polymerisate des Dicyclopentadiens, nicht hydrierte, partiell, selektiv oder vollständig hydrierte Kohlenwasserstoffharze auf Basis von C5-, C5/C9- oder C9-Monomerströmen, Polyterpenharze auf Basis von α-Pinen und/oder ss-Pinen und/oder δ-Limonen, hydrierte Polymerisate von bevorzugt reinen C8-und C9-Aromaten eingesetzt werden. Vorgenannte Klebharze können sowohl allein als auch im Gemisch eingesetzt werden. Dabei können sowohl bei Raumtemperatur feste als auch flüssige Harze zum Einsatz kommen. Um eine hohe Alterungs- und UV-Stabilität zu gewährleisten sind hydrierte Harze mit einem Hydrierungsgrad von mindestens 90%, vorzugsweise von mindestens 95%, bevorzugt.

Des Weiteren sind unpolare Harze mit einem DACP-Wert (diacetone alcohol cloud point) oberhalb von 30°C und einem MMAP-Wert (mixed methylcylohexane aniline point) von größer 50°C, insbesondere mit einem DACP-Wert oberhalb von 37°C und einem MMAP-Wert größer 60°C bevorzugt. Der DACP-Wert und der MMAP-Wert geben jeweils die Löslichkeit in einem bestimmten Lösemittel an. Durch die Auswahl dieser Bereiche wird eine besonders hohe Permeationsbarriere, insbesondere gegen Wasserdampf, erreicht.

Weiter bevorzugt sind Harze mit einer Erweichungstemperatur (Ring/Kugel) von mehr als 95 °C, insbesondere mehr als 100 °C. Durch diese Auswahl wird eine besonders hohe Permeationsbarriere, insbesondere gegen Sauerstoff, erreicht.

Wenn eine Erhöhung der Klebkraft erreicht werden soll, sind dagegen insbesondere Harze mit einer Erweichungstemperatur unterhalb von 95 °C, insbesondere unterhalb von 90 °C bevorzugt.

Als weitere Additive können typischerweise genutzt werden:

- Plastifizierungsmittel, wie zum Beispiel Weichmacheröle, oder niedermolekulare flüssige Polymere, wie zum Beispiel niedermolekulare Polybutene
- primäre Antioxidanzien, wie zum Beispiel sterisch gehinderte Phenole
- sekundäre Antioxidanzien, wie zum Beispiel Phosphite oder Thioether
- Prozessstabilisatoren, wie zum Beispiel C-Radikalfänger
- Lichtschutzmittel, wie zum Beispiel UV-Absorber oder sterisch gehinderte Amine Verarbeitungshilfsmittel
- Endblockverstärkerharze sowie
- gegebenenfalls weitere Polymere von bevorzugt elastomerer Natur; entsprechend nutzbare Elastomere beinhalten unter anderem solche auf Basis reiner Kohlenwasserstoffe, zum Beispiel ungesättigte Polydiene wie natürliches oder synthetisch erzeugtes Polyisopren oder Polybutadien, chemisch im wesentlichen gesättigte Elastomere wie zum Beispiel gesättigte Ethylen-Propylen-Copolymere, α-Olefincopolymere, Polyisobutylen, Butylkautschuk, Ethylen-Propylenkautschuk, sowie chemisch funktionalisierte Kohlenwasserstoffe wie zum Beispiel halogenhaltige, acrylathaltige, allyl- oder vinyletherhaltige Polyolefine.

In einer Ausführungsform der vorliegenden Erfindung enthält die Heißschmelzklebemasse auch Füllstoffe, beispielhaft, aber nicht einschränkend erwähnt seien Oxide, Hydroxide, Carbonate, Nitride, Halogenide, Carbide oder gemischte Oxid-/ Hydroxid-/ Halogenid-verbindungen des Aluminiums, Siliciums, Zirkoniums, Titans, Zinns, Zinks, Eisens oder der (Erd)alkalimetalle. Hierbei handelt es sich im Wesentlichen um Tonerden z.B. Aluminiumoxide, Boehmit, Bayerit, Gibbsit, Diaspor und ähnliche. Ganz besonders geeignet sind Schichtsilicate wie beispielsweise Bentonit, Montmorillonit, Hydrotalcit, Hectorit, Kaolinit, Boehmit, Glimmer, Vermiculit oder deren Mischungen. Aber auch Ruße oder weitere Modifikationen des Kohlenstoffs, etwa Kohlenstoffnanoröhrchen können verwendet werden.

Bevorzugt werden als Füllstoffe der Heißschmelzklebmasse nanoskalige und/oder transparente Füllstoffe verwendet. Als nanoskalig wird ein Füllstoff vorliegend bezeichnet, wenn er in mindestens einer Dimension eine maximale Ausdehnung von etwa 100 nm, bevorzugt von etwa 10 nm, aufweist. Besonders bevorzugt werden solche in der Masse transparente Füllstoffe mit plättchenförmiger Kristallitstruktur und einem hohen Aspektverhältnis bei homogener Verteilung verwendet. Die Füllstoffe mit plättchenartiger Kristallitstruktur und Aspektverhältnissen weit über 100 haben in der Regel nur eine Dicke von einigen nm, die Länge bzw. die Breite der Kristallite kann aber bis zu einigen $\mu$m betragen. Derartige Füllstoffe werden ebenfalls als Nanopartikel bezeichnet. Die partikuläre Ausgestaltung der Füllstoffe mit kleinen Abmessungen ist zudem besonders vorteilhaft für eine transparente Auslegung der Heißschmelzklebemasse.

Durch den Aufbau labyrinthartiger Strukturen mithilfe der zuvor beschriebenen Füllstoffe in der Klebstoffmatrix wird der Diffusionsweg von zum Beispiel Sauerstoff und Wasserdampf derartig verlängert, dass ihre Permeation durch die Klebstoffschicht hindurch vermindert wird. Zur besseren Dispergierbarkeit dieser Füllstoffe in der Bindemittelmatrix können diese Füllstoffe mit organischen Verbindungen oberflächlich modifiziert: werden. Der Einsatz derartiger Füllstoffe an sich ist beispielsweise aus der US 2007/0135552 A1 sowie der WO 02/026908 A1 bekannt.

In einer weiteren vorteilhaften Ausführung der vorliegenden Erfindung werden auch Füllstoffe, die mit Sauerstoff und/oder Wasserdampf in besonderer Weise wechselwirken können, eingesetzt. In die (opto-)elektronische Anordnung eindringender Sauerstoff oder Wasserdampf wird dann an diesen Füllstoffen chemisch oder physikalisch gebunden. Diese Füllstoffe werden auch als "getter", "scavenger", "desiccants" oder "absorber" bezeichnet. Solche Füllstoffe umfassen beispielhaft, aber nicht einschränkend: oxidierbare Metalle, Halide, Salze, Silicate, Oxide, Hydroxide, Sulfate, Sulfite, Carbonate von Metallen und Übergangsmetallen, Perchlorate und aktivierten Kohlenstoff, einschließlich seiner Modifikationen. Beispiele sind Cobaltchlorid, Calciumchlorid, Calciumbromid, Lithiumchlorid, Zinkchlorid, Zinkbromid, Siliciumdioxid (Silica Gel), Aluminiumoxid (aktiviertes Aluminium), Calciumsulfat, Kupfersulfat, Natriumdithionit, Natriumcarbonat, Magnesiumcarbonat, Titandioxid, Bentonit, Montmorillonit, Diatomenerde, Zeolithe und Oxide von (Erd)Alkalimetallen, wie Bariumoxid, Calciumoxid, Eisenoxid und Magesiumoxid oder auch Kohlenstoffnanoröhrchen. Desweiteren können auch organische Absorber eingesetzt werden, beispielsweise Polyolefin-Copolymere, Polyamid-Copolymere, PET-Copolyester oder weitere auf Hybridpolymeren basierte Absorber, die meist in Kombination mit Katalysatoren wie beispielsweise Cobalt verwendet werden. Weitere organische Absorber sind etwa schwach vernetzte Polyacrylsäure, Ascorbate, Glucose, Gallussäure oder ungesättigte Fette und Öle.

Um eine möglichst gute Wirksamkeit der Füllstoffe hinsichtlich der Barrierewirkung zu erzielen sollte ihr Anteil nicht zu gering sein. Der Anteil beträgt vorzugsweise mindestens 5 Gew.-%, weiter bevorzugt mindestens 10 Gew.-% und ganz bevorzugt mindestens 15 Gew.-%. Typischerweise wird ein möglichst hoher Anteil von Füllstoffen eingesetzt, ohne dabei die Klebkräfte der Heißschmelzklebemasse zu stark herabzusetzen oder weitere Eigenschaften zu beeinträchtigen. Der Anteil beträgt daher in einer Auslegung maximal 95 Gew.-%, bevorzugt maximal 70 Gew.-%, weiter bevorzugt maximal 50 Gew.-%.

Des Weiteren ist eine möglichst feine Verteilung und möglichst hohe Oberfläche der Füllstoffe vorteilhaft. Dies ermöglicht einen höheren Wirkungsgrad und eine höhere Beladungskapazität und wird insbesondere mit nanoskaligen Füllstoffen erreicht.

Im Gegensatz zu nicht vernetzten Heißschmelzklebmassen auf Basis von Vinylaromatenblockcopolymeren oder auch auf Basis von Polyisobutylen zeigen die erfindungsgemäßen Klebmassen bei Verklebung zwischen zwei Polyesterfolien, die zusätzlich eine Barriereschicht besitzen, keine Blasen nach Lagerung bei 85°C und 85%rF.

Die Herstellung und Verarbeitung der Heißschmelzklebemasse kann aus Lösung, Dispersion sowie aus der Schmelze erfolgen. Bevorzugt erfolgt die Herstellung und Verarbeitung aus Lösung oder aus der Schmelze. Besonders bevorzugt ist die Fertigung der Klebmasse aus Lösung. Dabei werden die Bestandteile der Heißschmelzklebemasse in einem geeigneten Lösungsmittel, zum Beispiel Toluol oder Mischungen aus Benzin und Aceton, gelöst und mit allgemein bekannten Verfahren auf den Träger aufgebracht. Bei der Verarbeitung aus der Schmelze können dies Auftragsverfahren über eine Düse oder einen Kalander sein. Bei Verfahren aus der Lösung sind Beschichtungen mit Rakeln, Messern, Walzen oder Düsen bekannt, um nur einige zu nennen.

In einer bevorzugten Ausführung enthält die Heißschmelzklebemasse nicht mehr flüchtige organische Verbindungen (VOC) als 50 $\mu$g Kohlenstoff pro Gramm Masse, insbesondere nicht mehr als 10 $\mu$g C/g, gemessen nach VDA 277. Dies hat den Vorteil besserer Verträglichkeit mit den organischen Materialien des elektronischen Aufbaus sowie mit eventuell vorhandenen Funktionsschichten, wie z.B. einer transparenten leitfähigen Metalloxidschicht ,wie z.B. Indium-Zinn-Oxid, oder einer solchen Schicht aus intrinsisch leitfähigem Polymer.

Die Heißschmelzklebemasse kann entweder zur vollflächigen Verklebung von (opto)-elektronischen Anordnungen verwendet werden oder nach entsprechender Konfektionierung können Stanzlinge, Rollen oder sonstige Formkörper aus der Heißschmelzklebemasse oder dem Heißschmelzklebeband hergestellt werden. Entsprechende Stanzlinge und Formkörper der Heißschmelzklebemasse / des Heißschmelzklebebandes werden dann vorzugsweise auf das zu verklebende Substrat aufgeklebt, etwa als Umrandungen oder Begrenzung einer (opto-)elektronischen Anordnung. Die Wahl der Form des Stanzlings oder des Formkörpers ist nicht eingeschränkt und wird abhängig von der Art der (opto-)elektronischen Anordnung gewählt. Die Möglichkeit der flächigen Laminierung ist, im Vergleich zu Flüssigklebstoffen durch die Erhöhung der Permeationsweglänge durch seitliches Eindringen der Permeanten von Vorteil für die Barriereeigenschaften der Masse, da die Permeationsweglänge sich umgekehrt proportional auf die Permeation auswirkt.

Sofern die Heißschmelzklebemasse in Form eines flächigen Gebildes mit einem Träger bereitgestellt wird, ist bevorzugt, dass die Dicke des Trägers bevorzugt im Bereich von etwa $\mu$m 1 bis etwa 350 $\mu$m liegt, weiter bevorzugt

zwischen etwa 4 μm und etwa 250 μm und besonders bevorzugt zwischen etwa 12 μm und etwa 150 μm. Die optimale Dicke hängt von der (opto-)elektronischen Anordnung, der Endanwendung und der Art der Ausführung der Heißschmefzklebemasse ab. Sehr dünne Träger im Bereich von 1 bis 12 μm werden eingesetzt bei (opto-) elektronische Aufbauten, die eine geringe Gesamtdicke erreichen sollen, es wird jedoch der Aufwand für die Integration in den Aufbau erhöht. Sehr dicke Träger zwischen 150 und 350 μm werden eingesetzt wenn eine erhöhte Permeationsbarriere durch den Träger und die Steifigkeit des Aufbaus im Vordergrund stehen; die Schutzwirkung wird durch den Träger erhöht, während die Flexibilität des Aufbaus verringert wird. Der bevorzugte Bereich zwischen 12 und 150 μm stellt für die meisten (opto-) elektronischen Aufbauten einen optimalen Kompromiss als Verkapselungslösung dar.

Weitere Einzelheiten, Ziele, Merkmale und Vorteile der vorliegenden Erfindung werden nachfolgend anhand bevorzugter Ausführungsbeispiele näher erläutert. In der Zeichnung zeigt

Fig. 1    eine erste (opto-)elektronische Anordnung in schematischer Darstellung,

Fig. 2    eine zweite (opto-)elektronische Anordnung in schematischer Darstellung,

Fig. 3    eine dritte (opto-)elektronische Anordnung in schematischer Darstellung.

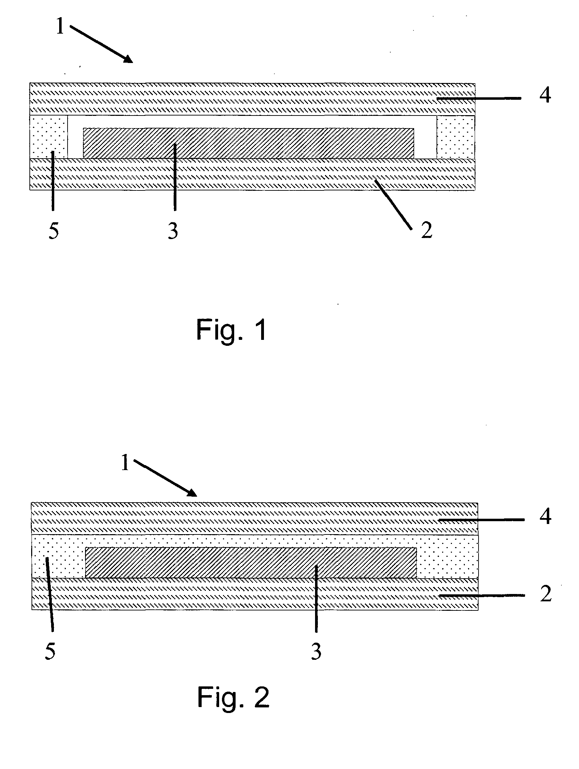

Fig. 1 zeigt eine erste Ausgestaltung einer (opto-)elektronischen Anordnung 1. Diese Anordnung 1 weist ein Substrat 2 auf, auf dem eine elektronische Struktur 3 angeordnet ist. Das Substrat 2 selbst ist als Barriere für Permeanten ausgebildet und bildet damit einen Teil der Kapselung der elektronischen Struktur 3. Oberhalb der elektronischen Struktur 3, vorliegend auch räumlich von dieser beabstandet, ist eine weitere als Barriere ausgebildete Abdeckung 4 angeordnet.

Um die elektronische Struktur 3 auch zur Seite hin zu kapseln und gleichzeitig die Abdeckung 4 mit der elektronischen Anordnung 1 im Übrigen zu verbinden, ist eine Heißschmelzklebemasse 5 umlaufend neben der elektronischen Struktur 3 auf dem Substrat 2 vorgesehen. Die Heißschmelzklebemasse 5 verbindet die Abdeckung 4 mit dem Substrat 2. Durch eine entsprechend dicke Ausgestaltung ermöglicht die Heißschmelzklebemasse 5 zudem die Beabstandung der Abdeckung 4 von der elektronischen Struktur 3.

Bei der Heißschmelzklebemasse 5 handelt es sich um eine solche auf Basis von vernetzten Vinylaromatenblockcopolymeren wie sie vorstehend in allgemeiner Form beschrieben wurde und nachfolgend in Ausführungsbeispielen näher dargelegt ist. Die Heißschmelzklebemasse 5 übernimmt vorliegend nicht nur die Funktion des Verbindens des Substrats 2 mit der Abdeckung 4 sondern bildet zudem auch eine Barriereschicht für Permeanten bereit, um so die elektronische Struktur 2 auch von der Seite gegen Permeanten wie Wasserdampf und Sauerstoff zu kapseln.

Die Heißschmelzklebemasse 5 wird vorliegend zudem in Form eines Stanzlings aus einem doppelseitigen Klebebandes bereitgestellt. Ein derartiger Stanzling ermöglicht eine besonders einfache Applikation.

Fig. 2 zeigt eine alternative Ausgestaltung einer (opto-)elektronischen Anordnung 1. Gezeigt ist wiederum eine elektronische Struktur 3, die auf einem Substrat 2 angeordnet und durch das Substrat 2 von unten gekapselt ist. Oberhalb und seitlich von der elektronischen Struktur ist nun die Heißschmelzklebemasse 5 vollflächig angeordnet. Die elektronische Struktur 3 wird somit an diesen Stellen durch die Heißschmelzklebemasse 5 gekapselt. Auf die Heißschmelzklebemasse 5 ist sodann eine Abdeckung 4 aufgebracht. Diese Abdeckung 4 muss im Gegensatz zu der vorherigen Ausgestaltung nicht zwingend die hohen Barriereanforderungen erfüllen, da die Barriere bereits durch die Heißschmelzklebemasse bereitgestellt wird. Die Abdeckung 4 kann beispielsweise lediglich eine mechanische Schutzfunktion wahrnehmen, sie kann aber auch zusätzlich als Permeationsbarriere vorgesehen sein.

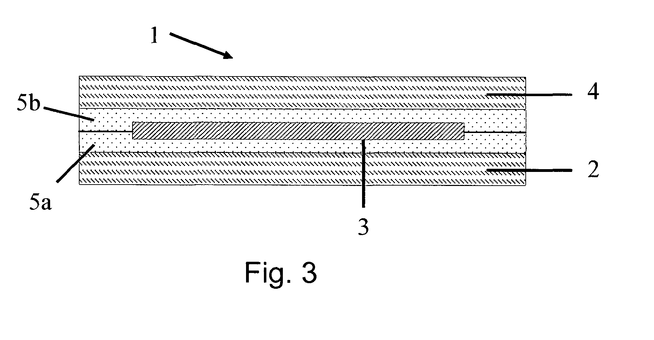

Fig. 3 zeigt eine weitere alternative Ausgestaltung einer (opto-)elektronischen Anordnung 1. Im Gegensatz zu den vorherigen Ausgestaltungen sind nun zwei Heißschmelzklebemassen 5a, b vorgesehen, die vorliegend identisch ausgebildet sind. Die erste Heißschmelzklebemasse 5a ist vollflächig auf dem Substrat 2 angeordnet. Auf der Heißschmelzklebemasse 5a ist dann die elektronische Struktur 3 vorgesehen, die durch die Heißschmelzklebemasse 5a fixiert wird. Der Verbund aus Heißschmelzklebemasse 5a und elektronischer Struktur 3 wird dann mit der weiteren Heißschmelzklebemasse 5b vollflächig überdeckt, so dass die elektronische Struktur 3 von allen Seiten durch die Heißschmelzklebemassen 5a, b gekapselt ist. Oberhalb der Heißschmelzklebemasse 5b ist dann wiederum die Abdeckung 4 vorgesehen.

In dieser Ausgestaltung müssen somit weder das Substrat 2 noch die Abdeckung 4 zwingend Barriereeigenschaften aufweisen. Sie können aber dennoch vorgesehen sein, um die Permeation von Permeanten zur elektronischen Struktur 3 weiter einzuschränken. Insbesondere im Hinblick auf die Fig. 2,3 wird darauf hingewiesen, dass es sich vorliegend um schematische Darstellungen handelt. Aus den Darstellungen ist insbesondere nicht ersichtlich, dass die Heißschmelzklebemasse 5 hier und vorzugsweise jeweils mit einer homogenen Schichtdicke aufgetragen wird. Am Übergang zur elektronischen Struktur bildet sich daher keine scharfe Kante, wie es in der Darstellung scheint, sondern der Übergang ist fließend und es können vielmehr kleine un- oder gasgefüllte Bereiche verbleiben. Ggf. kann jedoch auch eine Anpassung an den Untergrund erfolgen, insbesondere dann, wenn die Applikation unter Vakuum durchgeführt wird. Zudem wird die Heißschmelzklebemasse lokal unterschiedlich stark komprimiert, so dass durch Fließprozesse ein gewisser Ausgleich der Höhendifferenz an den Kantenstrukturen erfolgen kann. Auch die gezeigten Dimensionen sind nicht maßstäblich, sondern dienen vielmehr nur einer besseren Darstellung. Insbesondere die elektronische Struktur selbst ist in der Regel relativ flach ausgebildet (oft weniger als 1 $\mu$m dick).

Die Applikation der Heißschmelzklebemasse 5 erfolgt in allen gezeigten Ausführungsbeispielen in Form eines Heißschmelzklebebandes. Dabei kann es sich grundsätzlich um ein doppelseitiges Heißschmelzklebeband mit einem Träger, um eine hitzeaktivierbare Folie oder um ein Transferklebeband handeln. Vorliegend ist eine Ausgestaltung als hitzeaktivierbare Folie gewählt.

Die Dicke der Heißschmelzklebemasse, die entweder als Transferklebeband, als hitzeaktivierbare Folie oder auf einem flächigen Gebilde beschichtet vorliegt, beträgt bevorzugt zwischen etwa 1 $\mu$m und etwa 150 $\mu$m, weiter bevorzugt zwischen etwa 5 $\mu$m und etwa 75 $\mu$m und besonders bevorzugt zwischen etwa 12 $\mu$m und 50 $\mu$m. Hohe Schichtdicken zwischen 50 $\mu$m und 150 $\mu$m werden dann eingesetzt wenn eine verbesserte Haftung auf dem Substrat und/oder eine dämpfende Wirkung innerhalb des (opto-) elektronischen Aufbaus erreicht werden soll. Nachteilig ist hier jedoch der erhöhte Permeationsquerschnitt. Geringe Schichtdicken zwischen 1 $\mu$m und 12 $\mu$m reduzieren den Permeationsquerschnitt, damit die laterale Permeation und die Gesamtdicke des (opto-) elektronischen Aufbaus. Jedoch kommt es zu einer Verringerung der Haftung aus dem Substrat. In den besonders bevorzugten Dickenbereichen liegt ein guter Kompromiss zwischen einer geringen Massendicke und dem daraus folgenden niedrigen Permeationsquerschnitt, der die Permeation verringert, und einem genügend dicken Massefilm zur Herstellung einer ausreichend haftenden Verbindung vor. Die optimale Dicke hängt vom (opto-)elektronischen Aufbau, der Endanwendung, der Art der Ausführung der Heißschmelzklebemasse und gegebenenfalls dem flächigen Substrat ab.

Beispiele

Sofern nicht anders angegeben, sind alle Mengenangaben in den nachfolgenden Beispielen Gewichtsprozente bzw. Gewichtsteile bezogen auf die Gesamtzusammensetzung.

Prüfmethoden

*Klebkraft*

Die Bestimmung der Klebkraft wurde wie folgt durchgeführt: Als definierter Haftgrund wurde eine Stahlfläche und eine Polyethylenterephthalatplatte (PET) eingesetzt. Das zu untersuchende verklebbare Flächenelement wurde auf eine Breite von 20 mm und eine Länge von etwa 25 cm zugeschnitten, mit einem Handhabungsabschnitt versehen und bei 100°C in einer Heizpresse bei einem Druck von etwa 1 MPa verklebt.. Nach dem Abkühlen wurde das zuvor verklebte Flächenelement in einem Winkel von 180° bei Raumtemperatur und mit 300 mm/min vom Haftgrund mit einem Zugprüfungsgerät (Firma Zwick) abgezogen und die hierfür benötigte Kraft gemessen. Der Messwert (in N/cm) ergab sich als Mittelwert aus drei Einzelmessungen.

*Shear Adhesion Failure Temperature (SAFT)*

Die Bestimmung der SAFT wurde wie folgt durchgeführt: Als definierter Haftgrund wurde eine polierte Stahlfläche eingesetzt. Das zu untersuchende verklebbare Flächenelement wurde auf eine Breite von 10 mm und eine Länge von etwa 5 cm zugeschnitten und bei 100°C in einer Heizpresse bei einem Druck von etwa 1 MPa auf den jeweils gewählten Haftgrund mit einer Fläche von 10 x 13 mm verklebt. Nach dem Abkühlen wurde das zuvor verklebte Flächenelement in einem Winkel von 180° mit 0,5 N belastet und eine Temperaturrampe von 9°C/min gefahren. Dabei wurde die Temperatur gemessen, bei der die Probe eine Rutschstrecke von 1 mm zurückgelegt hat. Der Messwert (in °C) ergibt sich als Mittelwert aus zwei Einzelmessungen.

*Transmission*

Die Transmission der Klebemasse wurde über das VIS-Spektrum bestimmt. Die Aufnahmen des VIS-Spektrums wurden an einem UVIKON 923 der Firma Kontron durchgeführt. Der Wellenlängenbereich des gemessenen Spektrums umfasst alle Frequenzen zwischen 800 nm und 400 nm bei einer Auflösung von 1 nm. Dazu wurde die Klebemasse auf einen PET-Träger aufgebracht und vor der Messung wurde eine Leerkanalmessung des Trägers als Referenz über den gesamten Wellenlängenbereich durchgeführt. Für die Angabe des Ergebnisses wurden die Transmissionsmessungen im angegebenen Bereich gemittelt.

*Permeation*

Die Bestimmung der Permeabilität für Sauerstoff (OTR) und Wasserdampf (WVTR) erfolgte nach DIN 53380 Teil 3 bzw. ASTM F-1249. Die Heißschmelzklebemasse wurde dazu mit einer Schichtdicke von 50 $\mu$m ohne Trägermaterial vermessen.. Für die Sauerstoffdurchlässigkeit wurde bei 23°C und einer relativen Feuchte von 50 % gemessen. Die Wasserdampfdurchlässigkeit wurde bei 37,5°C und einer relativen Feuchte von 90 % bestimmt.

*Biegetest*

Für die Bestimmung der Flexibilität wurde die Klebemasse in einer Schichtdicke von 50 $\mu$m zwischen zwei 23 $\mu$m PET-Trägern bei 100°C gesiegelt und auf einen Biegeradius von 1 mm bei einer Biegung von 180° geprüft. Bestanden ist der Test, falls es nicht zum Bruch oder Ablösen der Schicht kommt.

*Lebensdauertest*

Als ein Maß für die Bestimmung der Lebensdauer eines (opto-)elektronischen Aufbaus wurde ein Calciumtest herangezogen. Dazu wird unter Stickstoffatmosphäre eine 20 x 20 mm$^2$ große, dünne Calciumschicht auf eine Glasplatte abgeschieden. Die Dicke der Calciumschicht liegt bei etwa 100 nm. Für die Verkapselung der Calciumschicht wird ein Klebeband mit der zu testenden Klebemasse sowie einer Dünnglasscheibe (35 $\mu$m, Fa. Schott) als Trägermaterial verwendet Das Klebeband wird mit einem allseitigen Rand von 3 mm über dem Calciumspiegel appliziert, in dem es mit einem Heißstempel mit einer Oberflächentemperatur von 100°C auf die Glasplatte geklebt wird. Aufgrund des undurchlässigen Glasträgers des Klebebands wird nur die Permeation durch den Heißschmelzkleber ermittelt.

Der Test basiert auf der Reaktion von Calcium mit Wasserdampf und Sauerstoff, wie sie beispielsweise von A.G. Erlat et. al. in "47th Annual Technical Conference Proceedings-Society of Vacuum Coaters", 2004, Seiten 654-659, und von M. E. Gross et al. in "46th Annual Technical Conference Proceedings-Society of Vacuum Coaters", 2003, Seiten 89-92, beschrieben sind. Dabei wird die Lichttransmission der Calciumschicht überwacht, welche durch die Umwandlung in Calciumhydroxid und Calciumoxid zunimmt. Diese erfolgt beim beschriebenen Prüfaufbau vom Rand her, so dass sich die sichtbare Fläche des Calciumspiegels verringert. Es wird die Zeit bis zur Halbierung der Fläche des Calciumspiegels als Lebensdauer bezeichnet. Als Messbedingungen werden 60°C und 90 % relative Luftfeuchte gewählt. Die Muster wurden mit einer Schichtdicke der Heißschmelzklebemasse von 15 $\mu$m vollflächig und blasenfrei verklebt.

*Blasentest*

Die Klebefolie wird auf eine mit einer anorganischen Barriereschicht versehenen PET-Barrierefolie mit einer Dicke von 25 $\mu$m (WVTR = 8x10$^{-2}$ g/m$^2$*d und OTR = 6x10$^{-2}$ cm3/m$^2$*d*bar,) wie oben beschreiben mit Hilfe einer Heißpresse bei 120°C verklebt. Anschließend wird die zweite Seite der Klebmasse mit derselben Folie ebenfalls unter der Heißpresse blasenfrei verklebt. Nach einer Aufziehzeit von 24h wird das präparierte Muster bei 85°C und 85%rF gelagert.. Untersucht wird, ob und wann in dem Verbund Blasen entstehen, sowohl die Anzahl der Blasen pro cm$^2$ als auch deren mittlere Größe wird bestimmt. Es wird die Dauer bis zum Erscheinen erster Blasen vermerkt.

*Herstellung der Muster*

Die Heißschmelzklebemassen in Beispiel 1 bis 3 wurden aus Lösung hergestellt. Dazu wurden die einzelnen Bestandteile in Toluol gelöst (Feststoffanteil 40%) und auf eine unbehandelte 23$\mu$m PET-Folie beschichtet und bei 120°C 15 Minuten lang getrocknet, so dass eine Klebmasseschicht mit einem Flächengewicht von 50 g/m$^2$ entstand. Für den Permeationstest wurden Muster in gleicher Weise erstellt, jedoch erfolgte die Beschichtung nicht auf eine PET-Folie sondern auf ein mit 1,5 g/m$^2$ silikonisiertes Trennpapier, so dass nach dem Abziehen von dem Trennpapier eine Messung an der puren Heißschmelzklebemasse vorgenommen werden konnte.

Beispiel 1

| 100 Teile | Kraton FG 1924 Maleinsäureanhydridmodifiziertes SEBS mit 13 % Blockpolystyrolgehalt, 36% Zweiblock und 1% Maleinsäure der Firma Kraton |
|---|---|
| 25 Teile | Escorez 5600 Hydriertes KW-Harz (Kohlenwasserstoffharz) mit einem Erweichungspunkt von 100°C der Firma Exxon |
| 1 Teil | Aluminium-acetylacetonat |

Beispiel 2

| 50 Teile | Kraton FG 1924 Maleinsäureanhydridmodifiziertes SEBS mit 13 % Blockpolystyrolgehalt, 36% Zweiblock und 1 % Maleinsäure der Firma Kraton |
|---|---|
| 50 Teile | Kraton FG 1901 Maleinsäureanhydridmodifiziertes SEBS mit 30% Blockpolystyrolgehalt, ohne Zweiblock und mit 1,7% Maleinsäure der Firma Kraton |
| 30 Teile | Escorez 5615 Hydriertes KW-Harz mit einem Erweichungspunkt von 115°C der Firma Exxon |
| 5 Teile | Ondina 917 Weißöl aus parafinischen und naphthenischen Anteilen der Firma Shell |
| 1 Teil | Aluminium-acetylacetonat |

Vergleichsbeispiel V3

| 100 Teile | Kraton G 1657 SEBS mit 13 % Blockpolystyrolgehalt der Firma Kraton Das SEBS enthält ca. 36% Zweiblockgehalt. |
|---|---|
| 20 Teile | Escorez 5600 Hydriertes KW-Harz mit einem Erweichungspunkt von 100°C der Firma Exxon |
| 5 Teile | Ondina 917 Weißöl aus parafinischen und naphthenischen Anteilen der Firma Shell |

Ergebnisse:

Zur klebtechnischen Beurteilung der oben genannten Beispiele wurden zunächst die Klebkraft, der SAFT-Test, Tack und der Test auf Flexibilität durchgeführt.

Tabelle 1

| | Klebkraft [N/cm] Stahl / PET | SAFT [°C] | Biegetest |
|---|---|---|---|
| Beispiel 1 | 4,2/3,7, | 180 | bestanden |
| Beispiel 2 | 4,7 / 4,3 | 180 | bestanden |
| V3 | 3,6 / 3,3 | 126 | bestanden |

Wie zu erkennen ist, konnten in allen Beispielen auf allen Untergründen ausreichende Klebkräfte und bei beiden Beispielen 1 und 2 exzellente Beständigkeiten bei erhöhten Temperaturen erreicht werden.

Die Ergebnisse der Permeations- und Transmissionsmessungen sind in Tabelle 2 zu finden.

Tabelle 2

| | WVTR g/(m$^2$*Tag) | OTR g/ m$^2$*Tag*bar) | Transmission [%] |
|---|---|---|---|
| Beispiel 1 | 25 | 5.550 | 90 |
| Beispiel 2 | 23 | 5.020 | 89 |
| V3 | 36 | 9.500 | 91 |

Wie zu erkennen ist, ist die Sperrwirkung der Heißschmelzklebemassen aus den ersten beiden Beispielen sogar etwas besser als beim Vergleichsbeispiel V3 und die Transmission im sichtbaren Bereich des Lichts ähnlich. Ersteres ist für den Fachmann überraschend, da durch die Funktionalisierung die Polarität der Massen steigt und somit zumindest die WVTR gegenüber der unpolareren Vergleichsklebemasse höher sein sollte.

Ergebnisse des Lebensdauertests:

Tabelle 3

| | Lebensdauer [h] | Blasentest [Zeit in h] |
|---|---|---|
| Beispiel 1 | 420 | Keine Blasen nach 14 Tagen |

(fortgesetzt)

| | Lebensdauer [h] | Blasentest [Zeit in h] |
|---|---|---|
| Beispiel 2 | 380 | Keine Blasen nach 14 Tagen |
| V3 | 120 | Erste Blasen nach 2h |

Die Lebensdauertests zeigen ähnliche Ergebnisse wie nicht vernetzte Vinylaromatenblockcopolymermassen. Im Blasentest zeigt sich eine deutliche Verbesserung, die Blasen im Vergleichsbeispiel waren nach 20 Stunden im Mittel ca. $410\mu$m im Durchmesser, die Anzahl lag bei ca. 180 Blasen pro $cm^2$.

**Patentansprüche**

1. Verfahren zur Kapselung einer elektronischen Anordnung gegen Permeanten,
   bei dem eine zumindest teilweise vernetzte Heißschmelzklebmasse auf Basis von säure- oder säureanhydridmodifizierten Vinylaromatenblockcopolymeren bereitgestellt wird und
   bei dem die Heißschmelzklebemasse auf und/oder um die zu kapselnden Bereiche der elektronischen Anordnung appliziert wird.

2. Verfahren nach Anspruch 1, **dadurch gekennzeichnet,**
   **dass** die Heißschmelzklebemasse in Form eines Klebebandes bereitgestellt wird.

3. Verfahren nach Anspruch 1 oder 2, **dadurch gekennzeichnet,**
   **dass** die Heißschmelzklebemasse mit Aminen oder Epoxidharzen vernetzt wird.

4. Verfahren nach Anspruch 1 oder 2, **dadurch gekennzeichnet,**
   **dass** die Heißschmelzklebemasse mit Metallchelaten vernetzt wird.

5. Verwendung einer Heißschmelzklebemasse zur Kapselung einer elektronischen Anordnung gegen Permeanten, insbesondere in einem Verfahren nach einem der vorhergehenden Ansprüche,
   **dadurch gekennzeichnet,**
   **dass** die Heißschmelzklebemasse auf säure- oder säureanhydridfunktionalisierten Vinylaromatenblockcopolymeren basiert.

6. Verwendung nach Anspruch 5, **dadurch gekennzeichnet,**
   **dass** die Heißschmelzklebemasse Polymerblöcke gebildet aus Vinylaromaten, insbesondere Styrol, enthält, und
   **dass** die Heißschmelzklebemasse Polymerblöcke gebildet durch Polymerisation von 1,3-Dienen, insbesondere Butadien und/oder Isopren,
   und/oder spezifisch oder vollständig hydrierte Polymerblöcke enthält.

7. Verwendung nach einem der Ansprüche 5 oder 6, **dadurch gekennzeichnet,**
   **dass** die modifizierten Vinylaromatenblockcopolymere durch Amine vernetzt sind.

8. Verwendung nach einem der Ansprüche 5 oder 6, **dadurch gekennzeichnet,**
   **dass** die modifizierten Vinylaromatenblockcopolymere durch Epoxidharze vernetzt sind.

9. Verwendung nach einem der Ansprüche 5 oder 6, **dadurch gekennzeichnet,**
   **dass** die modifizierten Vinylaromatenblockcopolymere durch Metallchelate vernetzt sind.

10. Verwendung nach Anspruch 9, **dadurch gekennzeichnet,**
    **dass** die Metallchelate durch die folgende Formel wiedergegeben werden können:

$$(R_1O)_n \, M \, (XR_2Y)_m,$$

wobei

M ein Metall der 2. 3. 4. und 5. Hauptgruppe oder ein Übergangsmetall ist;
$R_1$ eine Alkyl- oder Arylgruppe wie Methyl, Ethyl, Butyl, Isopropyl oder Benzyl ist; n null oder eine größere ganze Zahl ist,

X und Y Sauerstoff oder Stickstoff sind, die jeweils auch durch eine Doppelbindung an R2 gebunden sein können;

$R_2$ eine X und Y verbindende Alkylengruppe ist, die verzweigt sein kann, oder auch Sauerstoff oder weitere Heteroatome in der Kette enthalten kann;

m eine ganze Zahl, mindestens jedoch 1 ist.

11. Verwendung nach Anspruch 9 oder 10, wobei es sich bei dem Chelat um ein Acetylacetonat handelt.

12. Verwendung nach einem der Ansprüche 9 bis 11, wobei es sich bei dem Chelat um Aluminiumacetylacetonat handelt

13. Verwendung nach einem der Ansprüche 5 bis 12, **dadurch gekennzeichnet,**
    **dass** die Blockcopolymere einen Polyvinylaromatenanteil von 10 Gew.-% bis 35 Gew.-% aufweisen.

14. Verwendung nach einem der Ansprüche 5 bis 13, **dadurch gekennzeichnet,**
    **dass** die Heißschmeizklebemasse einen Anteil der Vinylaromatenblockcopolymere von mindestens 50 Gew.-%, vorzugsweise von mindestens 70 Gew.-%, weiter bevorzugt von mindestens 80 Gew.-%, aufweist und/oder
    **dass** die Heißschmelzklebemasse einen Anteil der Vinylaromatenblockcopolymere von maximal 100 Gew.-% aufweist

15. Verwendung nach einem der Ansprüche 5 bis 14, **dadurch gekennzeichnet,**
    **dass** die Heißschmelzklebemasse ein Harz oder ein Harzgemisch enthält, vorzugsweise hydrierte Harze mit einem Hydrierungsgrad von mindestens 90%, weiter bevorzugt von mindestens 95%.

16. Verwendung nach einem der Ansprüche 5 bis 15, **dadurch gekennzeichnet,**
    **dass** die Heißschmelzklebemasse ein oder mehrere Additive enthält, vorzugsweise ausgewählt aus der Gruppe bestehend aus: Plastifizierungsmitteln, primären Antioxidanzien, sekundären Antioxidanzien, Prozessstabilisatoren, Lichtschutzmitteln, Verarbeitungshilfsmittel, Endblockverstärkerharzen, Polymeren, insbesondere elastomerer Natur.

17. Verwendung nach einem der Ansprüche 5 bis 16, **dadurch gekennzeichnet,**
    **dass** die Heißschmelzklebemasse einen oder mehrere Füllstoffe enthält, vorzugsweise nanoskalige Füllstoffe, transparente Füllstoffe und/oder Getter- und/oder Scavenger-Füllstoffe.

18. Verwendung nach Anspruch 17, **dadurch gekennzeichnet,**
    **dass** die Füllstoffe in mindestens einer Dimension nanoskalig ausgebildet sind

19. Verwendung nach einem der Ansprüche 5 bis 18, **dadurch gekennzeichnet,**
    **dass** die Heißschmelzklebemasse transparent ausgebildet ist,
    vorzugsweise, dass die Heißschmelzklebemasse im Wellenlängenbereich von 400 nm bis 800 nm einem mittleren Transmissionsgrad von mindestens 75%, weiter bevorzugt von mindestens 90%, aufweist.

20. Verwendung nach einem der Ansprüche 5 bis 19, **dadurch gekennzeichnet,**
    **dass** die Heißschmelzklebemasse UV-blockend im Wellenlängenbereich von 320 nm bis 400 nm ausgebildet ist, vorzugsweise im Wellenlängenbereich von 280 nm bis 400 nm, weiter vorzugsweise im Wellenlängenbereich von 190 nm bis 400 nm,
    wobei als UV-blockend ein mittlerer Transmissionsgrad von maximal 20%, vorzugsweise von maximal 10%, weiter bevorzugt von maximal 1 % bezeichnet wird.

21. Verwendung nach einem der Ansprüche 5 bis 20, **dadurch gekennzeichnet,**
    **dass** die Heißschmelzklebemasse eine WVTR kleiner 80 g/m$^2$·d, vorzugsweise kleiner 35 g/m$^2$·d aufweist und/oder
    **dass** die Heißschmelzklebemasse eine OTR kleiner 8000 g/m$^2$·d·bar, vorzugsweise kleiner 4000 g/m$^2$·d·bar, aufweist

22. Verwendung nach einem der Ansprüche 5 bis 21, **dadurch gekennzeichnet,**
    **dass** die Heißschmelzklebemasse als Klebeband, insbesondere als trägerfreies Klebeband, ausgebildet ist.

23. Verwendung nach einem der Ansprüche 5 bis 21, **dadurch gekennzeichnet,**
    **dass** die Heißschmelzklebemasse als Klebeband mit einem Träger mit einer WVTR von nicht mehr als 10$^{-2}$ g/m$^2$

d, bevorzugt von nicht mehr als $10^{-3}$g/m$^2$ d, ausgebildet ist.

24. Verwendung nach einem der Ansprüche 5 bis 23, **dadurch gekennzeichnet,**
    **dass** die Schichtdicke der Heißschmelzklebemasse in dem Klebeband mindestens 1 $\mu$m, vorzugsweise mindestens 5 $\mu$m, weiter bevorzugt mindestens 12 $\mu$m, beträgt und/oder
    **dass** die Schichtdicke der Heißschmelzklebemasse in dem Klebeband maximal 150 $\mu$m, vorzugsweise maximal 75 $\mu$m, weiter bevorzugt maximal 50 $\mu$m, beträgt.

25. Elektronische Anordnung mit einer elektronischen Struktur, insbesondere einer organischen elektronischen Struktur, und einer Heißschmelzklebmasse,
    wobei die elektronische Struktur zumindest teilweise durch die Heißschmelzklebmasse gekapselt ist,
    **dadurch gekennzeichnet,**
    **dass** die Heißschmelzklebmasse gemäß einem der Ansprüche 5 bis 24 ausgebildet ist.

## Claims

1. Method of encapsulating an electronic arrangement with respect to permeants,
   in which an at least partly crosslinked hotmelt adhesive based on acid-modified or acid-anhydride-modified vinylaromatic block copolymers is provided and in which the hotmelt adhesive is applied to and/or around the regions of the electronic arrangement that are to be encapsulated.

2. Method according to Claim 1, **characterized in that** the hotmelt adhesive is provided in the form of an adhesive tape.

3. Process according to Claim 1 or 2, **characterized in that**
   the hotmelt adhesive is crosslinked using amines or epoxy resins.

4. Process according to Claim 1 or 2, **characterized in that**
   the hotmelt adhesive is crosslinked using metal chelates.

5. Use of a hotmelt adhesive for encapsulating an electronic arrangement with respect to permeants, more particularly in a method according to any of the preceding claims,
   **characterized in that**
   the hotmelt adhesive is based on acid-modified or acid-anhydride-modified vinylaromatic block copolymers.

6. Use according to Claim 5, **characterized in that** the hotmelt adhesive comprises polymer blocks formed from vinylaromatics, more particularly styrene, and
   **in that** the hotmelt adhesive comprises polymer blocks formed by polymerization of 1,3-dienes, more particularly butadiene ad/or isoprene,
   and/or specifically or fully hydrogenated polymer blocks.

7. Use according to either of Claims 5 and 6, **characterized in that**
   the modified vinylaromatic block copolymers are crosslinked by amines.

8. Use according to either of Claims 5 and 6, **characterized in that**
   the modified vinylaromatic block copolymers are crosslinked by epoxy resins.

9. Use according to either of Claims 5 and 6, **characterized in that**
   the modified vinylaromatic block copolymers are crosslinked by metal chelates.

10. Use according to Claim 9, **characterized in that** the metal chelates may be represented by the following formula:

$$(R_1O)_n \, M \, (XR_2Y)_m,$$

where

   M is a metal from main group 2, 3, 4 or 5 or a transition metal;
   $R_1$ is an alkyl or aryl group such as methyl, ethyl, butyl, isopropyl or benzyl;

n is zero or a larger integer,

X and Y are oxygen or nitrogen, and may each also be joined to R$_2$ by a double bond;

R$_2$ is an alkylene group which joins X and Y and which may be branched, or else may comprise oxygen or other heteroatoms in the chain;

m is an integer, but is at least 1.

11. Use according to Claim 9 or 10, the chelate being an acetylacetonate.

12. Use according to any of Claims 9 to 11, the chelate being aluminium acetylacetonate.

13. Use according to any of Claims 5 to 12, **characterized in that**
the block copolymers have a polyvinylaromatic fraction of 10% to 35% by weight.

14. Use according to any of Claims 5 to 13, **characterized in that**
the hotmelt adhesive has a vinylaromatic block copolymer fraction of at least 50%, preferably of at least 70%, more preferably to at least 80%, by weight, and/or
**in that** the hotmelt adhesive has a vinylaromatic block copolymer fraction of not more than 100% by weight.

15. Use according to any of Claims 5 to 14, **characterized in that**
the hotmelt adhesive comprises a resin or a resin mixture,
preferably hydrogenated resins having a degree of hydrogenation of at least 90%, more preferably of at least 95%.

16. Use according to any of Claims 5 to 15, **characterized in that**
the hotmelt adhesive comprises one or more additives, preferably selected from the group consisting of: plasticizers, primary antioxidants, secondary antioxidants, in-process stabilizers, light stabilizers, processing assistants, endblock reinforcer resins, polymers, especially elastomeric in nature.

17. Use according to any of Claims 5 to 16, **characterized in that**
the hotmelt adhesive comprises one or more fillers, preferably nanoscale fillers, transparent fillers and/or getter and/or scavenger fillers.

18. Use according to Claim 17, **characterized in that** the fillers are of nanoscale form in at least one dimension.

19. Use according to any of Claims 5 to 18, **characterized in that**
the hotmelt adhesive is transparent in form,
preferably **in that** the hotmelt adhesive has an average transmittance of at least 75%, more preferably of at least 90%, in the wavelength range from 400 nm to 800 nm.

20. Use according to any of Claims 5 to 19, **characterized in that**
the hotmelt adhesive is of UV-blocking design in the wavelength range from 320 nm to 400 nm, preferably in the wavelength range from 280 nm to 400 nm, more preferably in the wavelength range from 190 nm to 400 nm, UV-blocking denoting an average transmittance of not more than 20%, preferably of not more than 10%, more preferably of not more than 1%.

21. Use according to any of Claims 5 to 20, **characterized in that**
the hotmelt adhesive has a WVTR of less than 80 g/m$^2$·d, preferably less than 35 g/m$^2$·d, and/or
**in that** the hotmelt adhesive has an OTR of less than 8000 g/m$^2$·d·bar, preferably less than 4000 g/m$^2$·d·bar.

22. Use according to any of Claims 5 to 21, **characterized in that**
the hotmelt adhesive is in the form of an adhesive tape, more particularly a carrier-free adhesive tape.

23. Use according to any of Claims 5 to 21, **characterized in that**
the hotmelt adhesive is designed as an adhesive tape having a carrier having a WVTR of not more than 10$^{-2}$ g/m$^2$ d, preferably of not more 10$^{-3}$ g/m$^2$ d.

24. Use according to any of Claims 5 to 23, **characterized in that**
the layer thickness of the hotmelt adhesive in the adhesive tape is at least 1 $\mu$m, preferably at least 5 $\mu$m, more preferably at least 12 $\mu$m, and/or

**in that** the layer thickness of the hotmelt adhesive in the adhesive tape is not more than 150 $\mu$m, preferably not more than 75 $\mu$m, more preferably not more than 50 $\mu$m.

25. Electronic arrangement having an electronic structure, more particularly an organic electronic structure, and a hotmelt adhesive,
the electronic structure being at least partly encapsulated by the hotmelt adhesive,
**characterized in that**
the hotmelt adhesive is of a form according to any of Claims 5 to 24.

**Revendications**

1. Procédé d'encapsulation d'un dispositif électronique contre des produits de perméation, dans lequel une masse adhésive thermofusible au moins partiellement réticulée à base de copolymères à blocs d'aromatiques de vinyle modifiés par un acide ou un anhydride d'acide est mise à disposition et dans lequel la masse adhésive thermofusible est appliquée sur et/ou autour des zones à encapsuler du dispositif électronique.

2. Procédé selon la revendication 1, **caractérisé en ce que** la masse adhésive thermofusible est mise à disposition sous forme d'une bande adhésive.

3. Procédé selon la revendication 1 ou 2, **caractérisé en ce que** la masse adhésive thermofusible est réticulée par des amines ou des résines époxyde.

4. Procédé selon la revendication 1 ou 2, **caractérisé en ce que** la masse adhésive thermofusible est réticulée par des chélates métalliques.

5. Utilisation d'une masse adhésive thermofusible pour l'encapsulation d'un dispositif électronique contre des produits de perméation, en particulier dans un procédé selon l'une quelconque des revendications précédentes, **caractérisé en ce que** la masse adhésive thermofusible est à base de copolymères à blocs d'aromatiques de vinyle fonctionnalisés par un acide ou un anhydride d'acide.

6. Utilisation selon la revendication 5, **caractérisée en ce que** la masse adhésive thermofusible contient des blocs polymères formés à partir d'aromatiques de vinyle, en particulier du styrène, et **en ce que** la masse adhésive thermofusible contient des blocs polymères formés par polymérisation de 1,3-diènes, en particulier de butadiène et/ou d'isoprène, et/ou contient des blocs polymères spécifiquement ou complètement hydrogénés.

7. Utilisation selon l'une quelconque des revendications 5 à 6, **caractérisée en ce que** les copolymères à blocs d'aromatiques de vinyle modifiés sont réticulés par des amines.

8. Utilisation selon l'une quelconque des revendications 5 à 6, **caractérisée en ce que** les copolymères à blocs d'aromatiques de vinyle modifiés sont réticulés par des résines époxyde.

9. Utilisation selon l'une quelconque des revendications 5 à 6, **caractérisée en ce que** les copolymères à blocs d'aromatiques de vinyle modifiés sont réticulés par des chélates métalliques.

10. Utilisation selon la revendication 9, **caractérisée en ce que** les chélates métalliques peuvent être représentés par les formules suivantes :

$$(R_1O)_nM(XR_2Y)_m,$$

où

M représente un métal du 2ème, 3ème, 4ème et 5ème groupe principal ou un métal de transition ;
$R_1$ représente un groupe alkyle ou aryle, tel que méthyle, éthyle, butyle, isopropyle ou benzyle ;
n vaut zéro ou un nombre entier plus grand,
X et Y représentent oxygène ou azote, qui peuvent également être liés à chaque fois par une double liaison à $R_2$ ;
$R_2$ représente un groupe alkylène reliant X et Y, qui peut être ramifié, ou qui peut également contenir oxygène ou d'autres hétéroatomes dans la chaîne ;

m vaut un nombre entier, cependant au moins 1.

11. Utilisation selon la revendication 9 ou 10, où il s'agit, pour le chélate, d'un acétylacétonate.

12. Utilisation selon l'une quelconque des revendications 9 à 11, où il s'agit, pour le chélate, d'acétylacétonate d'aluminium.

13. Utilisation selon l'une quelconque des revendications 5 à 12, **caractérisée en ce que** les copolymères à blocs présentent une proportion de poly(aromatique de vinyle) de 10% en poids à 35% en poids.

14. Utilisation selon l'une quelconque des revendications 5 à 13, **caractérisée en ce que** la masse adhésive thermofusible présente une proportion de copolymères à blocs d'aromatiques de vinyle d'au moins 50% en poids, de préférence d'au moins 70% en poids, plus préférablement d'au moins 80% en poids et/ou **en ce que** la masse adhésive thermofusible présente une proportion de copolymères à blocs d'aromatiques de vinyle d'au maximum 100% en poids.

15. Utilisation selon l'une quelconque des revendications 5 à 14, **caractérisée en ce que** la masse adhésive thermofusible contient une résine ou un mélange de résines, de préférence des résines hydrogénées présentant un degré d'hydrogénation d'au moins 90%, plus préférablement d'au moins 95%.

16. Utilisation selon l'une quelconque des revendications 5 à 15, **caractérisée en ce que** la masse adhésive thermofusible contient un ou plusieurs additifs, de préférence choisis dans le groupe constitué par : les plastifiants, les antioxydants primaires, les antioxydants secondaires, les stabilisateurs de traitement, les agents de protection contre la lumière, les adjuvants de transformation, les résines de renforcement des blocs terminaux, les polymères, en particulier de nature élastomère.

17. Utilisation selon l'une quelconque des revendications 5 à 16, **caractérisée en ce que** la masse adhésive thermofusible contient une ou plusieurs charges, de préférence des charges nanométriques, des charges transparentes et/ou des charges absorbantes et/ou désactivantes.

18. Utilisation selon la revendication 17, **caractérisée en ce que** les charges sont réalisées de manière nanométrique dans au moins une dimension.

19. Utilisation selon l'une quelconque des revendications 5 à 18, **caractérisée en ce que** la masse adhésive thermofusible est réalisée de manière transparente, de préférence **en ce que** la masse adhésive thermofusible présente, dans la plage de longueurs d'ondes de 400 nm à 800 nm, un degré de transmission moyen d'au moins 75%, plus préférablement d'au moins 90%.

20. Utilisation selon l'une quelconque des revendications 5 à 19, **caractérisée en ce que** la masse adhésive thermofusible est réalisée de manière à bloquer les UV dans la plage de longueurs d'ondes de 320 nm à 400 nm, de préférence dans la plage de longueurs d'ondes de 280 nm à 400 nm, plus préférablement dans la plage de longueurs d'ondes de 190 nm à 400 nm,
"de manière à bloquer les UV" signifiant un degré de transmission moyen d'au maximum 20%, de préférence d'au maximum 10%, plus préférablement d'au maximum 1%.

21. Utilisation selon l'une quelconque des revendications 5 à 20, **caractérisée en ce que** la masse adhésive thermofusible présente un WVTR (taux de transmission de la vapeur d'eau) inférieur 80 $g/m^2{*}j$, de préférence inférieur à 35 $g/m^2{*}j$ et/ou **en ce que** la masse adhésive thermofusible présente un OTR (taux de transmission de l'oxygène) inférieur 8000 $g/m^2{*}j{*}bar$, de préférence inférieur à 4000 $g/m^2{*}j{*}bar$.

22. Utilisation selon l'une quelconque des revendications 5 à 21, **caractérisée en ce que** la masse adhésive thermofusible est réalisée sous forme de bande adhésive, en particulier sous forme de bande adhésive sans support.

23. Utilisation selon l'une quelconque des revendications 5 à 21, **caractérisée en ce que** la masse adhésive thermofusible est réalisée sous forme d'une bande adhésive présentant un support présentant un WVTR qui n'est pas supérieur à $10^{-2}$ $g/m^2{*}j$, de préférence pas supérieur à $10^{-3}$ $g/m^2{*}j$.

24. Utilisation selon l'une quelconque des revendications 5 à 23, **caractérisée en ce que** l'épaisseur de couche de la masse adhésive thermofusible dans la bande adhésive est d'au moins 1 $\mu$m, de préférence d'au moins 5 $\mu$m, plus préférablement d'au moins 12 $\mu$m et/ou **en ce que** l'épaisseur de couche de la masse adhésive thermofusible dans la bande adhésive est d'au maximum 150 $\mu$m, de préférence d'au maximum 75 $\mu$m, plus préférablement d'au maximum 50 $\mu$m.

25. Dispositif électronique présentant une structure électronique, en particulier une structure électronique organique et une masse adhésive thermofusible, la structure électronique étant encapsulée en moins en partie par la masse adhésive thermofusible **caractérisé en ce que** la masse adhésive thermofusible est réalisée selon l'une quelconque des revendications 5 à 24.

Fig. 1

Fig. 2

1

5b

5a

4

2

3

Fig. 3

**EP 2 465 149 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9821287 A1
- US 4051195 A
- US 4552604 A
- US 20040225025 A1
- WO 2006107748 A
- WO 2007111607 A
- US 20060100299 A1
- WO 2007087281 A1
- US 20050227082 A
- DE 102008047964
- DE 102008060113
- US 20060100299 A
- WO 03065470 A1
- JP 2002260847 B

- US 5488266 A
- WO 2008036707 A2
- WO 2003002684 A
- JP 2008004561 B
- JP 2005298703 B
- US 20040216778 A
- WO 2009085736 A2
- US 4633032 A
- US 2003143423 A1
- WO 2008043660 A1
- EP 1311559 B1
- US 20070135552 A1
- WO 02026908 A1

**In der Beschreibung aufgeführte Nicht-Patentliteratur**

- **VON A.G. ERLAT.** *47th Annual Technical Conference Proceedings-Society of Vacuum Coaters,* 2004, 654-659

- **VON M. E. GROSS et al.** *46th Annual Technical Conference Proceedings-Society of Vacuum Coaters,* 2003, 89-92